# EUROPEAN PATENT SPECIFICATION

(11) **EP 3 560 906 B1**
(45) Date of publication and mention of the grant of the patent: **21.02.2024**
(21) Application number: 19178123.6
(22) Date of filing: 12.05.2017
(51) Int. Cl.: C04B 35/645, C04B 35/626, B32B 18/00, C23C 14/56, C23C 16/44, H01L 21/67, H01J 37/32

(54) **CORROSION-RESISTANT COMPONENTS AND METHODS OF MAKING**
KORROSIONSBESTÄNDIGE KOMPONENTEN UND VERFAHREN ZUR HERSTELLUNG
COMPOSANTS RÉSISTANT À LA CORROSION ET LEURS PROCÉDÉS DE FABRICATION

(30) Priority: 16.11.2016 US 201615353429
(43) Date of publication of application: 30.10.2019
(62) Divisional of application: 17729576.3
(73) Proprietor: Coorstek Inc., Golden, CO 80403 (US)
(72) Inventor: SIMPSON, Matthew, Colorado, 80439 (US); DIVAKAR, Ramesh, Colorado, 80007 (US); FILER, Alan, Colorado, 80504 (US)
(74) Representative: HGF

(56) References cited:
- EP-A2- 1 119 026
- EP-A2- 1 158 072
- US-A1- 2006 073 349
- US-B2- 7 462 407

## Description

### FIELD

The present disclosure relates generally to corrosion-resistant components for the processing of equipment, such as semiconductors, and to methods of making such corrosion-resistant components.

### BACKGROUND

The processing of semiconductors frequently involves corrosive gases such as halogens in association with strong electric and magnetic fields. This combination of a corrosive environment and strong electric/magnetic fields generates a need for corrosion-resistant insulators. It is generally accepted that the most corrosion-resistant insulating materials for such applications are rare earth compounds, such as yttrium oxide (also known as "yttria"). Unfortunately, rare earth compounds tend to be both expensive and mechanically weak. The industry therefore tends to use coatings of rare earth compounds on less expensive insulators like aluminum oxide.

Several different coating methods have been used for the insulators. Physical vapor deposition (PVD) coatings have been used. These have the drawback that they are costly to apply for thicknesses of more than 10 µm. Thick, dense layers tend to spall due to internal stresses in the as-deposited coatings. Strain-tolerant thick PVD coatings made are known to contain fissures between crystallites that create the potential for shedding particles. Chemical vapor deposition (CVD) for coating application has been used, but it suffers the similar drawbacks. High rate deposition tends to produce fissures between grains. Denser coatings made by CVD are characterized by a grain size that tends to be small, typically less than 100 nm. Aerosol deposition has been used and it also suffers from cost limitations and an inability to make thick coatings that do not spall. Thermal plasma spray is the most widely used coating technology in the semiconductor equipment industry, but it cannot produce rare-earth coatings with porosity less than 1%, and therefore is prone to the shedding of particles. Furthermore, plasma spray coatings commonly contain a high density of microcracks (typically more than 100/mm²), and this, together with the porosity, leads to the shedding of particles.

US2006073349A1 discloses a ceramic member comprising a base including an alumina sintered body, and an yttria sintered body formed on the alumina sintered body and exposed to a corrosive gas; and a metallic member buried in the base.

EP1119026A2 discloses a wafer holder configured of a pair of ceramic base members and conductive layers each posed between the ceramic base members. The conductive layer has a body facing a wafer and an extraction extracted from the body for external connection, wherein the body and the extraction are arranged in a single plane. Thus there can be obtained a wafer holder for use with a semiconductor manufacturing apparatus that can reduce such distortion as caused when it is heated and cooled and that can also be readily manufactured.

Ceramic lids are commonly interposed between induction coils and induction plasma used for etching in the semiconductor industry. Insulating rings surrounding the wafer chuck and other chamber parts in etch and deposition equipment need to be corrosion-resistant as well as stable, for the reasons outlined above.

Another need in the semiconductor equipment industry is for high temperature corrosion-resistant wafer heaters. These needs are addressed by the corrosion-resistant components and assemblies of the invention.

### BRIEF SUMMARY

These and other needs are addressed by the various aspects, embodiments, and configurations of the present disclosure.

In an aspect of the invention is provided a corrosion-resistant component configured for use with a semiconductor processing reactor, the corrosion-resistant component comprising: a) a ceramic insulating substrate; b) a corrosion-resistant non-porous outer layer adhered to the ceramic insulating substrate, the corrosion-resistant non-porous outer layer having a thickness of at least 50 µm, a porosity of at most 1%, and a composition comprising at least 15% by weight of a rare earth compound based on total weight of the corrosion-resistant non-porous outer layer and a first sintering aid added to the rare-earth compound in the range from about 300 ppm to about 20% by weight based upon total weight of the rare-earth compound; c) at least one interposing layer embedded in the ceramic insulating substrate or layered between the ceramic insulating substrate and the corrosion-resistant non-porous outer layer, wherein the at least one interposing layer is ytterbium oxide, wherein the at least one interposing layer further comprises a second sintering aid added to the ytterbium oxide in the range from about 300 ppm to about 20% by weight based upon total weight of the ytterbium oxide; and d) a carbon content of at most 1000 ppm.

The corrosion-resistant component according to paragraph [0009], wherein the ceramic insulating substrate is selected from the group consisting of aluminum oxide, aluminum nitride, silicon nitride, silicate-based materials and mixtures of two or more thereof.

The corrosion-resistant component according to either paragraph [0009] or [0010], wherein the rare earth compound is selected from the group consisting of yttrium oxide (Y2O3), yttrium silicates, yttrium fluorides, yttrium oxyfluorides, yttrium aluminates, nitrides, complex nitride compounds, and combinations of two or more thereof.

The corrosion-resistant component according to any of paragraphs [0009]-[0011], wherein the corrosion-resistant non-porous layer is adhered to the ceramic insulating substrate, and the corrosion-resistant non-porous layer has: a porosity of at most 1%; an adhesion strength of at least 20 MPa; and, a thickness of at least 50 µm.

The corrosion-resistant component according to any of paragraphs [0009]-[0012], wherein the corrosion-resistant non-porous layer has: a porosity of at most 0.5%; an adhesion strength of at least 30 MPa; a thickness of at least 100 µm; and, an average grain size of at least about 300 nm and at most about 30 µm.

The corrosion-resistant component according to any of paragraphs [0009]-[0013], wherein the ceramic insulating substrate is aluminum oxide and the rare earth compound is a trivalent rare earth oxide.

The corrosion-resistant component according to any of paragraphs [0009]-[0014], wherein the ceramic insulating substrate is aluminum nitride and the corrosion-resistant non-porous layer is a rare earth silicate.

The corrosion-resistant component according to any of paragraphs [0009]-[0015], wherein the corrosion-resistant component is a lid configured for releasable engagement with a plasma etch reactor and has a loss tangent of less than 1 × 10⁻⁴.

The corrosion-resistant component comprises at least one interposing layer embedded in the ceramic insulating substrate, or layered between the ceramic insulating substrate and the corrosion-resistant non-porous layer.

The at least one interposing layer is ytterbium oxide (Yb₂O₃) and a sintering aid is added to the ytterbium oxide in the range from about 300 ppm to about 20% by weight based upon total weight of the ytterbium oxide.

The corrosion-resistant component according to any of paragraphs [0009]-[0016], wherein the at least one interposing layer comprises conducting materials.

The corrosion-resistant component according to any of paragraphs [0009]-[0019], wherein the at least one interposing layer further comprises insulating materials.

The corrosion-resistant component according to any of paragraphs [0009]-[0020], wherein the at least one interposing layer is adhered to both the corrosion-resistant non-porous layer and to the ceramic insulating substrate, and the corrosion-resistant non-porous layer has: a porosity of at most 1%; an adhesion strength of at least 20 MPa; and, a thickness of at least 50 µm.

The present disclosure also includes a green laminate configured for use with a semiconductor processing reactor, the green laminate comprising: a first layer of green sinterable material selected from the group consisting of aluminum oxide, aluminum nitride, silicon nitride, silicate-based materials, and mixtures of two or more thereof; a second layer of green sinterable material selected from the group consisting of yttrium oxide (Y₂O₃), yttrium silicates, yttrium fluorides, yttrium oxyfluorides, yttrium aluminates, nitrides, complex nitride compounds, and combinations of two or more thereof; and, wherein upon heat treatment of the green laminate, the second layer has a porosity of at most 1% and an average grain size of at least about 100 nm and at most about 100 µm.

The green laminate according to paragraph [0022], wherein upon heat treatment of the green laminate, the second layer has a porosity of at most 0.5% and an average grain size of at least about 300 nm and at most about 30 µm.

The green laminate according to either paragraph [0022] or [0023], further comprising at least one interposing layer between the first and second layers, wherein the at least one interposing layer comprises green sinterable material selected from the group consisting of rare earth oxides, rare earth silicates, rare earth aluminates, and mixtures of two or more thereof.

The green laminate according to any of paragraphs [0022]-[0024], wherein the heat treatment is selected from the group consisting of hot pressing and hot isostatic pressing.

The present disclosure also includes an assembly configured for use in fabricating semiconductor chips, the assembly comprising: a reactor; and, a corrosion-resistant component including: a ceramic insulating substrate; and, a corrosion-resistant non-porous layer associated with the ceramic insulating substrate, the corrosion-resistant non-porous layer of a composition comprising at least 15% by weight of a rare earth compound based on total weight of the corrosion-resistant non-porous layer and is characterized by a microstructure substantially devoid of microcracks and fissures, and having: a thickness of at least 50 µm; a porosity of at most 1%; and, an average grain size of at least 100 nm and at most 100 µm.

The assembly according to paragraph [0026], wherein the ceramic insulating substrate is selected from the group consisting of aluminum oxide, aluminum nitride, silicon nitride, silicate-based materials and mixtures of two or more thereof.

The assembly according to either paragraph [0026] or [0027], wherein the rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof.

The assembly according to any of paragraphs [0026]-[0028], wherein the corrosion-resistant non-porous layer is adhered to the ceramic insulating substrate and has an adhesion strength of at least 20 MPa.

The assembly according to any of paragraphs [0026]-[0029], wherein the corrosion-resistant non-porous layer has: a thickness of at least 100 µm; a porosity of at most 0.5%; an adhesion strength of at least 30 MPa; and, an average grain size of at least about 300 nm and at most about 30 µm.

The assembly according to any of paragraphs [0026]-[0030], further comprising at least one interposing layer embedded in the ceramic insulating substrate, or layered between the ceramic insulating substrate and the corrosion-resistant non-porous layer.

The assembly according to any of paragraphs [0026]-[0031], wherein the at least one interposing layer is at least one material chosen from rare earth oxides, rare earth silicates, rare earth aluminates, and mixtures of two or more thereof, the at least one interposing layer further comprising a sintering aid added to the at least one material chosen from rare earth oxides, rare earth silicates, rare earth aluminates, and mixtures of two or more thereof.

The assembly according to any of paragraphs [0026]-[0032], wherein the at least one interposing layer is ytterbium oxide (Yb₂O₃) and a sintering aid is added to the ytterbium oxide in the range from about 300 ppm to about 20% by weight based upon total weight of the ytterbium oxide.

The assembly according to any of paragraphs [0026]-[0033], wherein the at least one interposing layer comprises conducting materials.

The assembly according to any of paragraphs [0026]-[0034], wherein the at least one interposing layer further comprises insulating materials.

The assembly according to any of paragraphs [0026]-[0035], wherein the at least one interposing layer is selected from the group consisting of ytterbium oxide (Yb₂O₃), molybdenum (Mo), tungsten (W), molybdenum disilicide (MoSi₂), tungsten carbide (WC), tungsten disilicide (WSi₂), and mixtures of two or more thereof.

The assembly according to any of paragraphs [0026]-[0036], wherein the reactor is a plasma etch reactor configured for plasma etching and the corrosion-resistant component is a lid configured for releasable engagement with the plasma etch reactor; and, wherein the lid has a loss tangent of less than 1 × 10⁻⁴.

The assembly according to any of paragraphs [0026]-[0037], wherein the reactor is a deposition reactor configured for in-situ cleaning with halogen gases and the corrosion-resistant component is a heater.

The assembly according to any of paragraphs [0026]-[0038], wherein the reactor is a deposition reactor configured for in-situ cleaning with halogen gases and the corrosion-resistant component is a showerhead.

The assembly according to any of paragraphs [0026]-[0039], wherein the substrate further includes at least one interposing conductive layer embedded therein, the conductive layer having a sheet resistivity of at most 10 Megaohm-cm and a coefficient thermal expansion difference of at most 4 × 10⁻⁶ /K relative to the coefficients of thermal expansion for the ceramic insulating substrate and the corrosion-resistant non-porous layer.

The present disclosure also includes a corrosion-resistant component configured for use with a semiconductor processing reactor, the corrosion-resistant component comprising: a) a ceramic insulating substrate; and, b) a corrosion-resistant non-porous layer associated with the ceramic insulating substrate, the corrosion-resistant non-porous layer having a composition comprising at least 15% by weight of a rare earth compound based on total weight of the corrosion-resistant non-porous layer; and, the corrosion-resistant non-porous layer characterized by a microstructure devoid of microcracks and fissures, and having an average grain size of at least 100 nm and at most 100 µm.

The corrosion-resistant component according to paragraph [0041], wherein the ceramic insulating substrate is selected from the group consisting of aluminum oxide, aluminum nitride, silicon nitride, silicate-based materials and mixtures of two or more thereof.

The corrosion-resistant component according to either paragraph [0041] or [0042], wherein the rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof.

The corrosion-resistant component according to any of paragraphs [0041]-[0043], wherein the corrosion-resistant non-porous layer is adhered to the ceramic insulating substrate, and the corrosion-resistant non-porous layer has: a porosity of at most 1%; an adhesion strength of at least 20 MPa; and, a thickness of at least 50 µm.

The corrosion-resistant component according to any of paragraphs [0041]-[0044], wherein the corrosion-resistant non-porous layer has: a porosity of at most 0.5%; an adhesion strength of at least 30 MPa; a thickness of at least 100 µm; and, an average grain size of at least 300 nm and at most 30 µm.

The corrosion-resistant component according to any of paragraphs [0041]-[0045], wherein the ceramic insulating substrate is aluminum oxide and the rare earth compound is a trivalent rare earth oxide.

The corrosion-resistant component according to any of paragraphs [0041]-[0046], wherein the ceramic insulating substrate is aluminum nitride and the corrosion-resistant non-porous layer is a rare earth silicate.

The corrosion-resistant component according to any of paragraphs [0041]-[0047], wherein the corrosion-resistant component is a lid configured for releasable engagement with a plasma etch reactor and has a loss tangent of less than 1 × 10⁻⁴.

The corrosion-resistant component according to any of paragraphs [0041]-[0048], further comprising at least one interposing layer embedded in the ceramic insulating substrate, or layered between the ceramic insulating substrate and the corrosion-resistant non-porous layer.

The corrosion-resistant component according to any of paragraphs [0041]-[0049], wherein the at least one interposing layer is at least one material chosen from rare earth oxides, rare earth silicates, rare earth aluminates, and mixtures of two or more thereof, the at least one interposing layer further comprising a sintering aid added to the at least one material chosen from rare earth oxides, rare earth silicates, rare earth aluminates, and mixtures of two or more thereof.

The corrosion-resistant component according to any of paragraphs [0041]-[0050], wherein the at least one interposing layer is ytterbium oxide (Yb₂O₃) and a sintering aid is added to the ytterbium oxide in the range from about 300 ppm to about 20% by weight based upon total weight of the ytterbium oxide.

The corrosion-resistant component according to any of paragraphs [0041]-[0051], wherein the at least one interposing layer comprises conducting materials.

The corrosion-resistant component according to any of paragraphs [0041]-[0052], wherein the at least one interposing layer further comprises insulating materials.

The corrosion-resistant component according to any of paragraphs [0041]-[0053], wherein the at least one interposing layer is adhered to both the corrosion-resistant non-porous layer and to the ceramic insulating substrate, and the corrosion-resistant non-porous layer has: a porosity of at most 1%; an adhesion strength of at least 20 MPa; and, a thickness of at least 50 µm.

The present disclosure also includes a green laminate configured for use with a semiconductor processing reactor, the green laminate comprising: a first layer of green sinterable material selected from the group consisting of aluminum oxide, aluminum nitride, silicon nitride, silicate-based materials, and mixtures of two or more thereof; a second layer of green sinterable material selected from the group consisting of yttrium oxide (Y₂O₃), yttrium silicates, yttrium fluorides, yttrium oxyfluorides, yttrium aluminates, nitrides, complex nitride compounds, and combinations of two or more thereof; and, wherein upon heat treatment of the green laminate, the second layer has a porosity of at most 1% and an average grain size of at least 100 nm and at most 100 µm.

The green laminate according to paragraph [0055], wherein upon heat treatment of the green laminate, the second layer has a porosity of at most 0.5% and an average grain size of at least 300 nm and at most 30 µm.

The green laminate according to either paragraph [0055] or [0056], further comprising at least one interposing layer between the first and second layers, wherein the at least one interposing layer comprises green sinterable material selected from the group consisting of rare earth oxides, rare earth silicates, rare earth aluminates, and mixtures of two or more thereof.

The green laminate according to any of paragraphs [0055]-[0057], wherein the heat treatment is selected from the group consisting of hot pressing and hot isostatic pressing.

The present disclosure also includes an assembly configured for use in fabricating semiconductor chips, the assembly comprising: a reactor; and, a corrosion-resistant component including: a ceramic insulating substrate; and, a corrosion-resistant non-porous layer associated with the ceramic insulating substrate, the corrosion-resistant non-porous layer of a composition comprising at least 15% by weight of a rare earth compound based on total weight of the corrosion-resistant non-porous layer and is characterized by a microstructure devoid of microcracks and fissures, and having: a thickness of at least 50 µm; a porosity of at most 1%; and, an average grain size of at least 100 nm and at most 100 µm.

The assembly according to paragraph [0059], wherein the ceramic insulating substrate is selected from the group consisting of aluminum oxide, aluminum nitride, silicon nitride, silicate-based materials and mixtures of two or more thereof.

The assembly according to either paragraph [0059] or [0060], wherein the rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof.

The assembly according to any of paragraphs [0059]-[0061], wherein the corrosion-resistant non-porous layer is adhered to the ceramic insulating substrate and has an adhesion strength of at least 20 MPa.

The assembly according to any of paragraphs [0059]-[0062], wherein the corrosion-resistant non-porous layer has: a thickness of at least 100 µm; a porosity of at most 0.5%; an adhesion strength of at least 30 MPa; and, an average grain size of at least 300 nm and at most 30 µm.

The assembly according to any of paragraphs [0059]-[0063], further comprising at least one interposing layer embedded in the ceramic insulating substrate, or layered between the ceramic insulating substrate and the corrosion-resistant non-porous layer.

The assembly according to any of paragraphs [0059]-[0064], wherein the at least one interposing layer is at least one material chosen from rare earth oxides, rare earth silicates, rare earth aluminates, and mixtures of two or more thereof, the at least one interposing layer further comprising a sintering aid added to the at least one material chosen from rare earth oxides, rare earth silicates, rare earth aluminates, and mixtures of two or more thereof.

The assembly according to any of paragraphs [0059]-[0065], wherein the at least one interposing layer is ytterbium oxide (Yb₂O₃) and a sintering aid is added to the ytterbium oxide in the range from about 300 ppm to about 20% by weight based upon total weight of the ytterbium oxide.

The assembly according to any of paragraphs [0059]-[0066], wherein the at least one interposing layer comprises conducting materials.

The assembly according to any of paragraphs [0059]-[0067], wherein the at least one interposing layer further comprises insulating materials.

The assembly according to any of paragraphs [0059]-[0068], wherein the at least one interposing layer is selected from the group consisting of ytterbium oxide (Yb₂O₃), molybdenum (Mo), tungsten (W), molybdenum disilicide (MoSi₂), tungsten carbide (WC), tungsten disilicide (WSi₂), and mixtures of two or more thereof.

The assembly according to any of paragraphs [0059]-[0069], wherein the reactor is a plasma etch reactor configured for plasma etching and the corrosion-resistant component is a lid configured for releasable engagement with the plasma etch reactor; and, wherein the lid has a loss tangent of less than 1 × 10⁻⁴.

The assembly according to any of paragraphs [0059]-[0070], wherein the reactor is a deposition reactor configured for in-situ cleaning with halogen gases and the corrosion-resistant component is a heater.

The assembly according to any of paragraphs [0059]-[0071], wherein the reactor is a deposition reactor configured for in-situ cleaning with halogen gases and the corrosion-resistant component is a showerhead.

The assembly according to any of paragraphs [0059]-[0072], wherein the substrate further includes at least one interposing conductive layer embedded therein, the conductive layer having a sheet resistivity of at most 10 Megaohm-cm and a coefficient thermal expansion difference of at most 4 × 10⁻⁶ /K relative to the coefficients of thermal expansion for the ceramic insulating substrate and the corrosion-resistant non-porous layer.

The present disclosure includes a method for preparing a corrosion-resistant component for use with a semiconductor processing reactor, comprising: laying up a thinner layer of a sinterable powder composition comprising at least 15% by weight based on total weight of the thinner layer of a rare earth compound, and a thicker layer of sinterable substrate material to form a pre-laminate; and, heat treating the pre-laminate to form a corrosion-resistant component including a corrosion-resistant non-porous outermost layer characterized by a microstructure devoid of microcracks and fissures, and having an average grain size of at least 100 nm and at most 100 µm.

The method according to paragraph [0074], wherein heat treating is selected from the group consisting of hot pressing and hot isostatic pressing.

The method according to either paragraph [0074] or [0075], wherein the sinterable substrate material is selected from the group consisting of aluminum oxide, aluminum nitride, silicate-based materials, and mixtures of two or more thereof.

The method according to any of paragraphs [0074]-[0076], wherein the rare earth compound is selected from the group consisting of yttrium oxide (Y₂O₃), yttrium silicates, yttrium fluorides, yttrium oxyfluorides, yttrium aluminates, nitrides, complex nitride compounds and combinations of two or more thereof.

The method according to any of paragraphs [0074]-[0077], wherein the sinterable substrate material is aluminum oxide and the rare earth compound is a trivalent rare earth oxide.

The method according to any of paragraphs [0074]-[0078], wherein the sinterable substrate material is aluminum nitride and the rare earth compound is a rare earth silicate.

The method according to any of paragraphs [0074]-[0079], wherein the corrosion-resistant component is a lid configured for releasable engagement with a plasma etch reactor.

The method according to any of paragraphs [0074]-[0080], wherein the lid has a has a loss tangent of less than 1 × 10⁻³.

The method according to any of paragraphs [0074]-[0081], wherein the lid has a has a loss tangent of less than 1 × 10⁻⁴.

The method according to any of paragraphs [0074]-[0082], further comprising laying up at least one additional sinterable powder composition layer interposed between the rare earth compound thinner layer and the substrate material thicker layer, prior to heat treating.

The method according to any of paragraphs [0074]-[0083], wherein the at least one additional sinterable powder composition comprises a compound or metal having a coefficient thermal expansion difference of at most 4 × 10⁻⁶ /K relative to the coefficients of thermal expansion for the ceramic insulating substrate and the corrosion-resistant non-porous outermost layer.

The method according to any of paragraphs [0074]-[0084], wherein the at least one additional sinterable powder composition comprises a compound, intermetallic compound, or metal selected from the group consisting of ytterbium oxide (Yb₂O₃), molybdenum (Mo), tungsten (W), niobium (Nb), molybdenum disilicide (MoSi₂), tungsten carbide (WC), tungsten disilicide (WSi₂), titanium carbide (TiC), titanium nitride (TiN), and mixtures of two or more thereof.

The method according to any of paragraphs [0074]-[0085], wherein the at least one additional sinterable powder composition further comprises an insulating material selected from the group consisting of alumina, aluminum nitride, aluminates, silicates and mixtures of two or more thereof.

The method according to any of paragraphs [0074]-[0086], wherein the at least one additional sinterable powder composition is ytterbium oxide (Yb₂O₃).

The method according to any of paragraphs [0074]-[0087], wherein the at least one additional sinterable powder composition comprises conducting materials.

The method according to any of paragraphs [0074]-[0088], wherein the at least one additional sinterable powder composition further comprises insulating materials.

The method according to any of paragraphs [0074]-[0089], wherein the semiconductor processing reactor is a deposition reactor configured for in-situ cleaning with halogen gases and the corrosion-resistant component is a heater.

The method according to any of paragraphs [0074]-[0090], wherein the semiconductor processing reactor is a deposition reactor configured for in-situ cleaning with halogen gases and the corrosion-resistant component is a showerhead.

The method according to any of paragraphs [0074]-[0091], wherein the sinterable substrate material further includes at least one interposing conductive layer embedded therein, the conductive layer having a sheet resistivity of at most 10 Megaohm-cm and a coefficient thermal expansion difference of at most 4 × 10⁻⁶ /K relative to the coefficients of thermal expansion for the ceramic insulating substrate and the corrosion-resistant non-porous outermost layer.

The present disclosure includes a corrosion-resistant component configured for use with a semiconductor processing reactor, the corrosion-resistant component comprising: a) a ceramic insulating substrate; and, b) a white corrosion-resistant non-porous outer layer associated with the ceramic insulating substrate, the white corrosion-resistant non-porous outer layer having a thickness of at least 50 µm, a porosity of at most 1%, and a composition comprising at least 15% by weight of a rare earth compound based on total weight of the corrosion-resistant non-porous layer; and, c) an L* value of at least 90 as measured on a planar surface of the white corrosion-resistant non-porous outer layer.

The corrosion-resistant component according to paragraph [0093], further comprising an L* value of at least 92 as measured on a planar surface of the white corrosion-resistant non-porous outer layer.

The corrosion-resistant component according to either paragraph [0093] or [0094], further comprising an L* value of at least 94 as measured on a planar surface of the white corrosion-resistant non-porous outer layer.

The corrosion-resistant component according to any of paragraphs [0093]-[0095], wherein the ceramic insulating substrate is selected from the group consisting of aluminum oxide, aluminum nitride, silicon nitride, silicate-based materials and mixtures of two or more thereof.

The corrosion-resistant component according to any of paragraphs [0093]-[0096], wherein the rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof.

The corrosion-resistant component according to any of paragraphs [0093]-[0097], wherein the rare earth compound is yttrium oxide (Y₂O₃).

The corrosion-resistant component according to any of paragraphs [0093]-[0098], wherein the white corrosion-resistant non-porous outer layer has a thickness of at least 100 µm, a porosity of at most 0.5%, and an average grain size of at most 50 µm.

The corrosion-resistant component according to any of paragraphs [0093]-[0099], wherein the white corrosion-resistant non-porous outer layer further comprises a sintering aid added to the rare-earth compound in the range from about 300 ppm to about 20% by weight based upon total weight of the rare-earth compound.

The corrosion-resistant component according to any of paragraphs [0093]-[00100], wherein the sintering aid added to the rare-earth compound is in the range from about 0.5% by weight to about 5% by weight based upon total weight of the rare-earth compound.

The corrosion-resistant component according to any of paragraphs [0093]-[00101], wherein the sintering aid is at least one material chosen from ZrO₂, HfO₂, and CeO₂.

The corrosion-resistant component according to any of paragraphs [0093]-[00102], wherein the sintering aid is ZrO₂ and is added to the rare-earth compound in the amount of 1% by weight based upon total weight of the rare-earth compound.

The corrosion-resistant component according to any of paragraphs [0093]-[00103], further comprising at least one interposing layer embedded in the ceramic insulating substrate, or layered between the ceramic insulating substrate and the white corrosion-resistant non-porous outer layer, wherein the at least one interposing layer is at least one material chosen from rare earth oxides, rare earth silicates, rare earth aluminates, and mixtures of two or more thereof.

The corrosion-resistant component according to any of paragraphs [0093]-[00104], wherein the at least one interposing layer is ytterbium oxide (Yb₂O₃).

The corrosion-resistant component according to any of paragraphs [0093]-[00105], wherein the at least one interposing layer further comprises a sintering aid added to the ytterbium oxide in the range from about 300 ppm to about 20% by weight based upon total weight of the ytterbium oxide.

The corrosion-resistant component according to any of paragraphs [0093]-[00106], wherein the at least one interposing layer further comprises conducting materials.

Also disclosed is an assembly configured for use in fabricating semiconductor chips, the assembly comprising: a reactor; and, the corrosion-resistant component according to any of paragraphs [0093]-[00107].

The assembly according to paragraph [00108], wherein the reactor is a plasma etch reactor configured for plasma etching and the corrosion-resistant component is a lid configured for releasable engagement with the plasma etch reactor; and, wherein the lid has a loss tangent of less than 1 × 10⁻⁴.

The assembly according to either paragraph [00108] or [00109], wherein the reactor is a deposition reactor configured for in-situ cleaning with halogen gases and the corrosion-resistant component is a heater.

The present disclosure includes a method for preparing a white corrosion-resistant component for use with a semiconductor processing reactor, comprising: laying up a first layer of a sinterable powder composition comprising at least 15% by weight based on total weight of the first layer of a rare earth compound, and a second layer of sinterable substrate material to form a pre-laminate, wherein the sinterable substrate material is selected from the group consisting of aluminum oxide, aluminum nitride, silicon nitride, silicate-based materials and mixtures of two or more thereof; and wherein the first layer is less than 50% as thick as the second layer; and, heat treating the pre-laminate to form a corrosion-resistant component including a white corrosion-resistant non-porous outer layer, having a thickness of at least 50 µm and a porosity of at most 1%, to form a corrosion-resistant laminate; and, heat treating the corrosion-resistant laminate further in air at a temperature from at least 800 °C to at most 1500 °C for a time from at least 0.5 h to at most 48 h to form a white corrosion-resistant component having an L* value of at least 90 as measured on a planar surface of the white corrosion-resistant non-porous outer layer.

The method according to paragraph [00111], wherein the white corrosion-resistant component has an L* value of at least 92 as measured on a planar surface of the corrosion-resistant non-porous outer layer.

The method according to either paragraph [00111] or [00112], wherein the white corrosion-resistant component has an L* value of at least 94 as measured on a planar surface of the corrosion-resistant non-porous outer layer.

The method according to any of paragraphs [00111]-[00113], wherein the rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof.

The method according to any of paragraphs [00111]-[00114], wherein the step of laying up a first layer of sinterable powder composition comprising at least 15% by weight based on total weight of the first layer of a rare earth compound further comprises a sintering aid added to the rare-earth compound in the range from about 300 ppm to about 20% by weight based upon total weight of the rare-earth compound.

The method according to any of paragraphs [00111]-[00115], wherein the sintering aid is at least one material chosen from ZrO₂, HfO₂, and CeO₂.

The method according to any of paragraphs [00111]-[00116], wherein the sintering aid added is in the amount of at least 0.5% by weight and at most 5% by weight based upon total weight of the rare-earth compound.

The method according to any of paragraphs [00111]-[00117], wherein the sintering aid added is ZrO₂ in the amount of about 1% by weight based upon total weight of the rare-earth compound.

The method according to any of paragraphs [00111]-[00118], wherein the step of laying up further comprises laying up at least one interposing layer of sinterable powder layered between the first layer and the second layer, wherein the at least one interposing layer of sinterable powder is at least one material chosen from rare earth oxides, rare earth silicates, rare earth aluminates, and mixtures of two or more thereof.

The method according to any of paragraphs [00111]-[00119], wherein the at least one interposing layer of sinterable powder is ytterbium oxide and further comprises a sintering aid added to the ytterbium oxide in the range from about 300 ppm to about 20% by weight based upon total weight of the ytterbium oxide.

The present disclosure includes a corrosion-resistant component configured for use with a semiconductor processing reactor, the corrosion-resistant component comprising: a) a ceramic insulating substrate; and, b) a white corrosion-resistant non-porous outer layer associated with the ceramic insulating substrate, the white corrosion-resistant non-porous outer layer having a thickness of at least 50 µm, a porosity of at most 1%, and a composition comprising at least 15% by weight of a rare earth compound based on total weight of the corrosion-resistant non-porous layer and a sintering aid added to the rare-earth compound in the range from about 300 ppm to about 20% by weight based upon total weight of the rare-earth compound, wherein the sintering aid is at least one material chosen from ZrO₂, HfO₂, and CeO₂; c) at least one interposing layer embedded in the ceramic insulating substrate, or layered between the ceramic insulating substrate and the corrosion-resistant non-porous layer, wherein the at least one interposing layer is at least one material chosen from rare earth oxides, rare earth silicates, rare earth aluminates, and mixtures of two or more thereof; and, d) an L* value of at least 90 as measured on a planar surface of the white corrosion-resistant non-porous outer layer.

The corrosion-resistant component according to paragraph [00121], wherein the at least one interposing layer is ytterbium oxide (Yb₂O₃) and further comprises a sintering aid added to the ytterbium oxide in the range from about 300 ppm to about 20% by weight based upon total weight of the ytterbium oxide.

The present invention includes a corrosion-resistant component configured for use with a semiconductor processing reactor, the corrosion-resistant component comprising: a) a ceramic insulating substrate; b) a corrosion-resistant non-porous outer layer associated with the ceramic insulating substrate, the corrosion-resistant non-porous layer having a thickness of at least 50 µm, a porosity of at most 1%, and a composition comprising at least 15% by weight of a rare earth compound based on total weight of the corrosion-resistant non-porous layer and a first sintering aid added to the rare-earth compound in the range from about 300 ppm to about 20% by weight based upon total weight of the rare-earth compound; c) at least one interposing layer embedded in the ceramic insulating substrate, or layered between the ceramic insulating substrate and the corrosion-resistant non-porous layer, wherein the at least one interposing layer is at least one material chosen from rare earth oxides, rare earth silicates, rare earth aluminates, and mixtures of two or more thereof; the at least one interposing layer further comprising a second sintering aid added to the at least one material chosen from rare earth oxides, rare earth silicates, rare earth aluminates, and mixtures of two or more thereof; and, d) a carbon content of at most 1000 ppm; wherein, the at least one interposing layer is ytterbium oxide and the second sintering aid is added to the ytterbium oxide in the range from about 300 ppm to about 20% by weight based upon total weight of the ytterbium oxide.

The corrosion-resistant component according to paragraph [00123], wherein the first sintering aid is at least one material chosen from ZrO₂, HfO₂, and CeO₂ and the second sintering is at least one material chosen from ZrO₂, HfO₂, and CeO₂.

The present invention includes also a method for preparing the corrosion-resistant component of paragraph [00123], the method comprising: laying up a first layer of a sinterable powder composition comprising at least 15% by weight of a rare earth compound based on total weight of the first layer, wherein a first sintering aid is added to the rare earth compound, and a second layer of sinterable substrate material to form a pre-laminate, wherein the sinterable substrate material is selected from the group consisting of aluminum oxide, aluminum nitride, silicon nitride, silicate-based materials and mixtures of two or more thereof; and wherein the first layer is less than 50% as thick as the second layer; laying up at least one interposing layer of sinterable powder layered between the first layer and the second layer, wherein the sinterable powder is ytterbium oxide; and wherein a second sintering aid is added to the interposing layer in the range from about 300 ppm to about 20% by weight based upon total weight of the ytterbium oxide; heat treating by either hot pressing or hot isostatic pressing the pre-laminate to form a corrosion-resistant component, including a corrosion-resistant non-porous outer layer, having a thickness of at least 50 µm and a porosity of at most 1%, to form a corrosion-resistant laminate having a carbon content of at most 1000 ppm.

### BRIEF DESCRIPTION OF THE DRAWINGS

FIG. 1A illustrates a cross-sectional view of an embodiment not forming part of the invention, such as a lid, including a corrosion-resistant component.
FIG. 1B illustrates a cross-sectional view of an embodiment, such as a lid, including a corrosion-resistant component according to another example aspect of the invention.
FIG. 2 illustrates an assembly for plasma etching of semiconductor chips, including a corrosion-resistant lid according to an example aspect of the invention.
FIG. 3 illustrates a cross-sectional view of a corrosion-resistant wafer heater according to an example aspect of the invention.
FIG. 4 illustrates a chemical vapor deposition reactor assembly including a wafer heater and a showerhead, each including a corrosion-resistant non-porous layer, according to an example aspect of the invention.
FIG. 5 illustrates a flow chart for a method of making a white corrosion-resistant component according to an example aspect of the invention.
FIG. 6A illustrates an assembly configured for use in plasma etching semiconductor wafers according to an example aspect of the invention.
FIG. 6B illustrates a top view of a corrosion-resistant component as shown in FIG. 6A.

### DETAILED DESCRIPTION

A ceramic substrate and a corrosion-resistant layer comprising a rare earth compound are sintered together to form a dense corrosion-resistant laminate or corrosion-resistant component. This is to solve the problem of coatings (via plasma spray coating operation, for example) being applied to previously sintered substrates, wherein the coating subsequently suffers from problems such as spalling or shedding particles during use. The heat treating of a thin rare earth compound layer on a suitable substrate material provides a corrosion-resistant component. In an example embodiment, the rare earth compound is yttrium oxide and the substrate material is a ceramic, such as aluminum oxide. In yet another example embodiment, the rare earth compound comprises a rare earth silicate such as yttrium silicate on an aluminum nitride substrate. In an example embodiment, a corrosion-resistant layer including a rare earth compound is co-sintered with insulating substrate materials to form corrosion-resistant ceramic lids, for example, that are commonly interposed between induction coils and induction plasma used for etching. In other example embodiments, corrosion-resistant components useful as insulating rings surrounding the wafer chuck and other chamber parts in etch and deposition reactors, such as wafer heaters and deposition showerheads, also benefit from this technology. Components, assemblies and methods of the present disclosure provide a way to meet the need for physically and chemically stable, corrosion-resistant layers and parts such as ceramic lids integral to the plasma reactors used in the semiconductor industry.

As used herein, various terms are defined as follows. "Alumina" is commonly understood to be aluminum oxide, substantially comprising Al₂O₃. "Yttria" is commonly understood to be yttrium oxide, substantially comprising Y₂O₃. "Ytterbia" is commonly understood to be ytterbium oxide, substantially comprising Yb₂O₃. The term "substantially" generally refers a purity of ≥90 wt%, preferably ≥91 wt% or ≥92 wt% or ≥93 wt% or ≥94 wt% or ≥95 wt% or ≥96 wt% or ≥97 wt% or ≥98 wt% or ≥99 wt% or about 100 wt%. The term "about" generally refers to plus or minus 10% of the indicated number. For example, "about 10%" may indicate a range of 9% to 11%, and "about 20" may mean from 18-22. Other meanings of "about" may be apparent from the context, such as rounding off, so, for example "about 1" may also mean from 0.5 to 1.4. The term "soak" (see Tables in the Examples) refers to the holding time at a particular temperature or pressure in a hot pressing cycle.

Other definitions include the following. "Adhesion strength" is measured by the ASTM C633 method. "Loss tangent" is the ratio of the imaginary part of the dielectric constant to the real part; it is directly proportional to the power absorbed by the component. "Color" is described using the 1976 CIELAB color space: this reduces colors to a lightness/darkness variable L*, for which absolute black is 0 and complete white is 100, and other parameters a* and b* which describe the hue of the object. Generally, an object having L* greater than 85 and absolute values of a* and b* of less than 7 are considered "white". "Porosity" is measured by image analysis of a polished section, polished according to the following scheme (polishing supplies provided by Struers, Inc.): (i) 60 µm diamond: as needed to flatten the surface; (ii) 15 µm diamond, fixed abrasive pad: 2 min; (iii) 9 µm diamond, Largo (plastic) pad: 8 min; (iv) 3 µm diamond, DAC (nylon) pad: 6 min; and, (v) 1 µm diamond, napped cloth: 3 min. "Grain size" is measured by the by ASTM-E112 method. "Green" or "unsintered" ceramics as referred to herein include ceramic materials or powders which have not been densified via a high temperature thermal process. "Sintered" or "Cosintered" refers to one or more ceramic materials that have been exposed to a high temperature thermal process to promote sintering. "Sintering" is a thermal or heat treatment process to promote material transport and densification through the gradual elimination of porosity. The sintering process is used to produce materials with controlled microstructure and porosity. "Coating" is a layer applied to a substrate, for example, a sintered substrate. "Laminate" or "composite laminate" is an assembly of layers that are joined via a process such as sintering, for example. "Component" is a part or product.

A reactor for semiconductor fabrication or semiconductor processing is useful for etching or deposition or both. A reactor is referred to interchangeably herein as a semiconductor processing reactor, a semiconductor fabrication reactor, or simply as reactor. Reactors are useful for plasma etching or deposition or both. In an example embodiment, both the ceramic insulating substrate and the corrosion-resistant non-porous layer are resistant to a plasma etching treatment employed in semiconductor processing. In an example embodiment, the corrosion-resistant component is a lid for a plasma etch reactor. Reactors used for deposition periodically run an etching process for cleaning of the reactor. It may be that the reactor is a deposition reactor configured for in-situ cleaning with halogen gases and the corrosion-resistant component is a heater. It may be that the reactor is a deposition reactor configured for in-situ cleaning with halogen gases and the corrosion-resistant component is a showerhead.

Ceramics are inorganic, non-metallic materials known for their ability to withstand high temperatures. Ceramics include oxides, non-oxides and composites (combinations of oxides and non-oxides). Oxides include, in non-limiting examples, alumina, glass-ceramics, beryllia, mullite, ceria, and zirconia. In a preferred embodiment the ceramic oxide is alumina (Al₂O₃). Non-oxides include carbides, borides, nitrides, and silicides. In another preferred embodiment, the non-oxide is a nitride, such as aluminum nitride (AlN). Ceramic oxides, non-oxides, and composites are useful as substrates.

A corrosion-resistant layer including a rare-earth element or compound is advantageously joined with a ceramic substrate and/or other layers to provide a laminate, wherein the outermost layer is corrosion-resistant and non-porous. Examples of rare-earth compounds include, but are not limited to trivalent rare earth oxides such as in an example embodiment, yttrium oxide (Y₂O₃). In other example embodiments, the rare earth compound is selected from the group consisting of yttrium oxide, yttrium silicates, yttrium fluorides, yttrium oxyfluorides, yttrium aluminates, nitrides, complex nitride compounds, and combinations of two or more thereof. In an example embodiment, the rare earth compound is Y₃Si₃O₁₀F. In other example embodiments, the rare earth compound is a complex nitride compound such as YN·Si₃N₄ or YN·AlN-Y₂O₃·2SiO₂, for example.

Sintering aids, as known to one of skill in the art, are useful for example to minimize porosity, reduce grain size, and/or to enable less extreme processing conditions to be employed (for example, lower pressures in hot pressing) for sintering. In an example aspect, a sintering aid is added to the rare-earth compound. In an example embodiment, the sintering aid added to the rare-earth compound is an oxide of tetravalent elements (*e.g.* Zr, Hf, Ce). In an example aspect, the amount of sintering aid added to the rare-earth compound is in the range from about 300 ppm to about 20% by weight based upon total weight of the rare-earth compound; in another example embodiment from about 0.5% by weight to about 15% by weight based upon total weight of the rare-earth compound. In an example embodiment, the amount of sintering aid added to the rare-earth compound is about 1% by weight, or about 2% by weight, or about 5% by weight, or about 10% by weight, or about 15% by weight. In an example embodiment, the sintering aid added to the rare-earth compound is ZrO₂ or HfO₂. In an example embodiment, where the rare-earth compound is yttria, for example, ZrO₂ is used as a sintering aid in the amount of about 1% by weight based upon total weight of the rare-earth compound. In another example embodiment, ZrO₂ is used as a sintering aid in the amount of about 15% by weight based upon total weight of the rare-earth compound. In an example embodiment for processing large parts such as a lid, for which maintaining pressure levels is challenging, about 1% by weight sintering aid is added to the rare-earth compound based upon total weight of the rare-earth compound.

Interposing layers can be placed between the substrate and the rare-earth compound containing corrosion-resistant layer in assembling the laminate. In an example embodiment, at least one interposing layer between a yttria layer and an alumina substrate is useful in order to detect wear of the outermost corrosion-resistant layer. Interposing layers may also advantageously include a rare-earth element or compound. In one aspect, ytterbium oxide (Yb₂O₃) is used as an interposing layer since its fluorescence at infrared (IR) wavelengths can be used to detect corrosion-resistant layer wear without producing a cosmetic color change of the material. As owners of semiconductor equipment frequently care about cosmetic issues, Yb₂O₃ layers offer the advantage of not being visible to the human eye (in other words colorless) while allowing detection of wear by irradiating with appropriate IR wavelengths and observing the fluorescence or absorption. The thickness of interposing layer(s) depends on function; typically interposing layers are at most about 2 mm in thickness. In an example embodiment, interposing layers such as conductive layers or bonding layers function acceptably at thicknesses of less than 10 µm.

In another example aspect, a sintering aid is added to the interposing layer. In an example embodiment, the sintering aid added to the interposing layer is an oxide of tetravalent elements (*e.g.* Zr, Hf, Ce). In an example aspect, the amount of sintering aid added to the interposing layer is in the range from about 300 ppm to about 20% by weight based upon total weight of the interposing layer; in another example embodiment from about 0.5% by weight to about 15% by weight based upon total weight of the interposing layer. In an example embodiment, the amount of sintering aid added to the interposing layer is about 1% by weight, or about 2% by weight, or about 5% by weight, or about 10% by weight, or about 15% by weight. In an example embodiment, the sintering aid added to the interposing layer is a material chosen from ZrO₂, HfO₂, and CeO₂. In other embodiments, the sintering aid is at least one material chosen from ZrO₂, HfO₂, CeO₂, and mixtures of two or more thereof. In another example, the sintering aid includes inert material such as a non-limiting example wherein zirconia as sintering aid further includes yttria, as in yttria stabilized zirconia. In an example embodiment, where the interposing layer is Yb₂O₃, for example, ZrO₂ is used as a sintering aid in the amount of about 1% by weight based upon total weight of the interposing layer. In another example embodiment, ZrO₂ is used as a sintering aid in the amount of about 15% by weight based upon total weight of the interposing layer. In an example embodiment for processing large parts such as a lid, for which maintaining pressure levels is challenging, about 1% by weight sintering aid is added to the interposing layer based upon total weight of the interposing layer.

In an example embodiment, the interposing layer includes a grain size in the range from 0.1 µm to 30 µm. In an example embodiment, the grain size of the interposing layer is at least 0.1 µm, or at least 0.3 µm, or at least 0.5 µm, or at least 1 µm, or at least 2 µm, or at least 4 µm. In an example embodiment, the grain size of the interposing layer is at most 30 µm, or at most 20 µm, or at most 15 µm, or at most 10 µm, or at most 6 µm, or at most 5 µm. The porosity of the interposing layer is at most about 3%, or at most about 2%, or at most about 1%. In an example aspect, the interposing layer is ytterbia (Yb₂O₃). The porosity of the interposing layer should be sufficiently low, but does not need to be as low as the porosity of the corrosion-resistant non-porous layer. This is because the interposing layer is not exposed to the processes such as plasma etching or deposition as is the corrosion-resistant non-porous layer.

Optionally, it may also be advantageous to include metal layers in the ceramic lid, insulating rings and other chamber parts that are commonly found in etching and deposition equipment. As noted above, ceramic lids, which are also referred to as ceramic windows or simply as lids or windows interchangeably herein, are commonly interposed between induction coils and induction plasma used for etching. The electrical resistance of a metal layer could also serve to monitor the temperature of the lid, thus enabling feedback control over its temperature. Embedding or interposing the layers within the lid or component simplifies the assembly of the system and also improves shielding and the coupling of the heat to the lid.

It is important to choose the materials of the embedded layers to match the thermal expansion coefficient of the bulk composite as well as to the individual layer(s) of the composite as mismatches tend to lead to delayed delamination within the component. Thermal expansion mismatches can be considered close or acceptable if the difference in thermal expansion coefficients is at most 4 × 10⁻⁶ /K relative to the coefficients for the ceramic insulating substrate and the corrosion-resistant non-porous layer. In an example embodiment, the at least one interposing layer is chosen to be a material having a thermal expansion coefficient difference of at most 4 × 10⁻⁶ /K relative to the coefficients for the ceramic insulating substrate and the corrosion-resistant non-porous layer. Thermal expansion mismatches can often be helped by making the layer a composite of several different materials, whose combined thermal expansion matches the expansion of the bulk of the part. In an example embodiment, MoSi₂ is a particularly suitable conductive intermetallic compound, because its thermal expansion is close to that of alumina, and it does not react with alumina at the high processing temperatures.

Since the components of the invention may operate in strong electromagnetic fields, minimizing the loss tangent is an important consideration. In an example embodiment, the corrosion-resistant component has a loss tangent of the component of at most 1 × 10⁻³, preferably at most 1 × 10⁻⁴. A component having a loss tangent of at most 1 × 10⁻⁴ is substantially transparent to radio-frequency (RF) energy. Excessive carbon content in the parts tends to promote high loss tangent and therefore carbon content should be minimized. Free carbon contents in excess of 2000 ppm are undesirable. The carbon content is at most 1000 ppm. In a further embodiment the carbon content is at most 500 ppm. Very low levels of carbon, for example at most 200 ppm carbon content by weight, are believed to also contribute to desirably light or white components according to the present disclosure. In one embodiment the carbon content is at most 200 ppm. In another embodiment the carbon content is at most 100 ppm. In yet another embodiment the carbon content is at most 50 ppm.

The presence or exposure to certain elements during the semiconductor processing, for example, can be undesirable. In applications for which light-colored ceramic components are desired, due to industry users being sensitive to the color of the components or parts as with semiconductor processing, undesired elements are to be avoided. Metal contamination in the parts (which affects the properties of transistors in the wafers processed in the equipment) can be visible as dark spots on the parts. Thus lighter colors for the parts are preferred as the spots show up more clearly. This enables problem or unacceptable parts to be identified and discarded before use. In an example embodiment, the corrosion-resistant component has a CIE Lab color L* parameter of at least 50. In another example embodiment, the corrosion-resistant component has a CIE Lab color L* parameter of at least 80.

In an example embodiment, the disks, windows, and/or components of the present disclosure are characterized as being "white" in color. Advantageously, uniformly white components of the present disclosure can be associated with defect free or substantially defect free components. That is because consumers in the semiconductor industry, for example, have typically observed defects to be non-white and a white component according to the present disclosure provides a white background by which defects are more readily detected with the human eye. Therefore, undesirable components can be culled out if need be rather than to be used in processing. White, defect free components are hence desirable to the consumer. Particularly desired is that the planar surface of the white component that is exposed to or facing a wafer to be processed, in a non-limiting example, be white.

Alternatively, or in addition to the component being characterized as white, the outer most layer of the component is characterized as being "white" in color. For components of the present invention, the outer most layer of the component corresponds to a corrosion-resistant non-porous outer layer, and is referred to herein as white corrosion-resistant non-porous outer layer or simply as white outer layer. Lightness of color and color uniformity may be observed visually by the eye. Alternatively, color and uniformity of color may be measured. As those skilled in the art appreciate, the color of the components may be measured, in a non-limiting example, by using standard instrumentation such as Hunterlab Miniscan XE instrument using the CIELAB L*a*b* scale. CIELAB L*a*b* values are also referred to as CIE Lab values or L*, a*, b* values interchangeably herein. Values for "L*" indicate the ratio of light to dark or, in other words, 'shading'. Values for "a*" and "b*" generally relate to 'hue'. Values for "a*" refer to the redness-greenness coordinate in certain transformed color spaces, generally used as the difference in "a*" between a specimen and a standard reference color. If "a*" is positive, there is more redness than greenness; if "a*" is negative, there is more greenness than redness. The value for a* is normally used with b* as part of the chromaticity or chromaticity color difference. Values for "b*" refer to the yellowness-blueness coordinate in certain color spaces, generally used as the difference in "b*" between a specimen and a standard reference color, normally used with "a*" or a as part of the chromaticity difference. Generally, if "b*" is positive, there is more yellowness than blueness; if "b*" is negative, there is more blueness than yellowness. In an example embodiment, the disks, windows, and/or components of the present disclosure are white in color. In one or more embodiments, the component has an L* value of at least 88, in other embodiments an L* value of at least 90, in other embodiments an L* value of at least 92, and in other embodiments an L* value of at least 94. The measured CIELAB L*a*b* values are obtained on a planar surface of the outer most layer of the component. In an example embodiment, the corrosion-resistant non-porous outer layer of the component is white. In one or more embodiments, the corrosion-resistant non-porous outer layer of the component has an L* value of at least 88, in other embodiments an L* value of at least 90, in other embodiments an L* value of at least 92, and in other embodiments an L* value of at least 94.

First row transition elements such as V, Cr, Mn, Fe, Co, Ni, Cu, and Zn, for example, diffuse relatively quickly through silicon and can alter the electrical properties of devices. The presence of Au and Ag can cause similar problems. In addition, elements such as Li, Na, and K diffuse quickly through silica and can affect the charge density on device gates. The corrosion-resistant component of the invention is substantially contaminant free. Total concentration of undesirable elements in the raw materials for making corrosion-resistant components is to be minimized. The total concentration of these undesirable elements should be substantially less than 1 at%. In an example embodiment, the total concentration of undesirable elements in raw materials used in making of the corrosion-resistant components is at most 1 at%.

Layer thickness for the outermost layer may be tailored to the component and its application for use. The outermost layer is the corrosion-resistant non-porous layer. Depending upon use, the outermost layer may be oriented toward the inside of a chamber or reactor, for example. For lids or windows, which are typically larger than 500 mm in diameter, relatively thick layers are desired. The as-fired profile of such a large component may depart by a millimeter or more from the desired profile; therefore, it is desirable for the as-fired thickness of the outermost layer to be substantially more than one millimeter thick, in order to ensure the presence of enough outermost material even after grinding. Thinner layers are more appropriately used on smaller parts, because departures from the true form are typically less.

The present disclosure is also directed to a corrosion-resistant component configured for use with a semiconductor processing reactor, the corrosion-resistant component comprising: a) a ceramic insulating substrate; and, b) a corrosion-resistant non-porous layer associated with the ceramic insulating substrate, the corrosion-resistant non-porous layer having a composition comprising at least 15% by weight of a rare earth compound based on total weight of the corrosion-resistant non-porous layer; and, the corrosion-resistant non-porous layer characterized by a microstructure substantially devoid of microcracks and fissures, and having an average grain size of at least about 100 nm and at most about 100 µm. In an example, the corrosion-resistant non-porous layer associated with the ceramic insulating substrate is adhered to the substrate. In an example, the corrosion-resistant non-porous layer is adhered directly to the substrate. In another example, the corrosion-resistant non-porous layer is adhered indirectly to the substrate, for example with interposing layers therebetween.

The microstructure of the corrosion-resistant non-porous layer is important to the durability and performance of the component. A component or laminate including a non-porous layer free of microcracks and fissures does not suffer deleterious effects such as particle shedding. In an example embodiment, the corrosion-resistant non-porous layer is characterized by a microstructure devoid of microcracks and fissures. In another example embodiment, the corrosion-resistant non-porous layer is characterized by a microstructure substantially devoid of microcracks and fissures. In an example embodiment, the corrosion-resistant non-porous layer has microcracks and fissures of less than 50 per mm², in an example embodiment less than 10 per mm², in another example embodiment less than 5 per mm², and in yet another example embodiment less than 1 per mm². In an example embodiment, the corrosion-resistant non-porous layer is characterized by a microstructure having microcracks and fissures of at most 1 per mm², as quantified by image analysis, for example, or other methods as known in the art. Whereas microcracks and fissures are deleterious to the microstructural integrity of the corrosion-resistant non-porous layer, second phases in the microstructure may conversely increase strength of the layer (refer to Example 10).

In an example embodiment, grain size of the corrosion-resistant non-porous layer is important to the performance of the component. Generally, corrosion occurs fastest at grain boundaries, thus materials with larger grain sizes corrode more slowly. In addition, if corrosion on boundaries is relatively rapid, entire grains can be dislodged by grain boundary corrosion. This is also referred to herein as particle loss or shedding. In an example embodiment, the corrosion-resistant component includes a corrosion-resistant non-porous layer having an average grain size as measured by ASTM-E112 of at least 100 nm. In an example embodiment, the corrosion-resistant non-porous layer is characterized as having an average grain size of at least 100 nm, or at least 150 nm, or at least 200 nm, or at least 300 nm, or at least 500 nm. However, problems may develop with overly large grain sizes, for example, the size of flaws weakening the material scales as the grain size; therefore, grain sizes larger than 100 µm are also undesirable. In an example embodiment, the corrosion-resistant non-porous layer is characterized as having an average grain size of at most 100 µm, or at most 30 µm, or at most 10 µm, or at most 1 µm, or at most 750 nm. Alternatively, the average grain size of the corrosion-resistant non-porous layer is in the range of about 100 nm to about 100 µm, preferably about 200 nm to about 50 µm, more preferably about 300 nm to about 30 µm. In another example embodiment, the average grain size of the corrosion-resistant non-porous layer is at least 300 nm and at most 30 µm.

In an example embodiment, grain size of the corrosion-resistant non-porous outer layer is important to the color of the component, particularly wherein a white component is desired. Without being bound by theory, it is believed that a uniform average grain size provides color uniformity, whereas the presence macroscopic areas (e.g. greater than 1 mm²) of large grain sizes and macroscopic areas (e.g. greater than 1 mm²) of small grain sizes within the layer may cause deleterious color variations. A smaller average grain size is believed to be advantageous in terms of providing color uniformity. This is believed to relate to transparency of the grains in the outer layer. The density of grain boundaries is less for a layer having a larger average grain size as compared to a layer having a smaller average grain size leading to more transparency for the layer comprising a larger average grain size. More transparency means that the outer layer transmits more light through from the material beneath the corrosion-resistant non-porous outer layer, ie. From the substrate, and may lead to lessening of the desired color lightness (or whiteness) or uniformity. In an example embodiment, a component characterized as white in color according to the present disclosure include a corrosion-resistant non-porous outer layer having an average grain size of at most 100 µm, at most 50 µm, or at most 30 µm, or at most 20 µm, or at most 10 µm, or at most 8 µm, or at most 6 µm. In an example embodiment, a component characterized as white in color according to the present disclosure include a corrosion-resistant non-porous outer layer having an average grain size of at least 500 nm, or at least 1 µm, or at least 2 µm, or at least 4 µm. Alternatively, the average grain size of the corrosion-resistant non-porous layer is in the range of about 500 nm to about 100 µm, preferably about 1 µm to about 50 µm, more preferably about 2 µm to about 10 µm. In another example embodiment, the average grain size of the corrosion-resistant non-porous layer is about 5 µm. Achieving acceptable color and/or color uniformity is challenging as components get larger, as those of skill and knowledge of in the art would recognize. In other words, it is more difficult to achieve uniform color on larger parts than smaller parts. In one embodiment of the present disclosure, uniformly white components are achieved for a component having a diameter of at least 400 mm, or in other embodiments at least 500 mm.

In an example embodiment, the corrosion-resistant component includes a corrosion-resistant non-porous layer having: a) a porosity of ≤1% or ≤0.9% or ≤0.8% or ≤0.7% or ≤0.6% or ≤0.5% or ≤0.4% or ≤0.3% or ≤0.2% or ≤0.1%; and b) an adhesion strength of ≥15 Mpa, preferably ≥20 Mpa or ≥25 Mpa or ≥30 Mpa or ≥35 Mpa or ≥40 Mpa; and c) a layer thickness of ≥50 µm, preferably ≥100 µm or ≥ 150 µm or ≥200 µm or ≥250 µm or ≥300 µm. Layer thickness, as mentioned previously, may be tailored to the application of use or component specifications desired. Alternatively, the layer thickness can be in the range of about 50 to about 500 µm, preferably about 100 to about 400 µm, more preferably about 150 to about 300 µm. In an example embodiment, the corrosion-resistant non-porous layer has: a porosity of at most 1%; an adhesion strength of at least 20 MPa; and, a layer thickness of at least 50 µm. In another example embodiment, the corrosion-resistant non-porous layer has: a porosity of at most 0.5%; an adhesion strength of at least 30 MPa; and, a layer thickness of at least 100 µm.

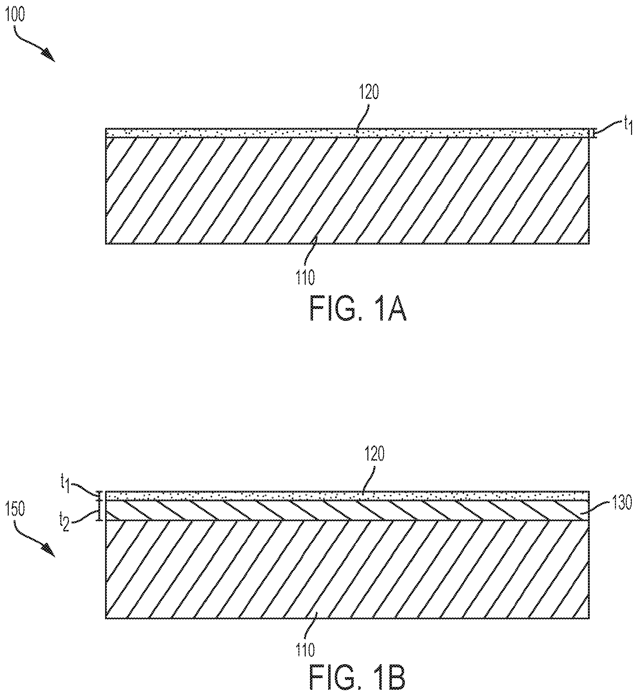

FIGs.1A and 1B illustrate cross-sectional schematic views of example aspects of corrosion-resistant components. In FIG. 1A, corrosion-resistant component 100 includes substrate 110 having corrosion-resistant non-porous layer 120 adjacent to the substrate 110 where layer 120 provides an outermost layer for the component. Layer 120 has thickness ti. In FIG. 1B, corrosion-resistant component 150 includes substrate 110 having interposing layer 130 situated between substrate 110 and corrosion-resistant non-porous layer 120. Layer 130 has thickness t₂. In one embodiment of the corrosion-resistant component both the substrate and the corrosion-resistant non-porous layer are resistant to the plasma etching conditions employed in semiconductor processing.

As shown in FIG. 1A, corrosion-resistant component 100 includes non-porous corrosion-resistant layer 120 comprising a rare earth compound. In an example embodiment, layer 120 comprises a trivalent rare earth oxide. In another example embodiment, the rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof. In another example embodiment, the rare earth compound is a complex nitride compound such as, for example, YN·Si₃N₄ or YN·AlN·Y₂O_{3·}2SiO₂.

In an example aspect, the corrosion-resistant component includes ceramic insulating substrate 110, as shown also in FIG. 1A, selected from the group consisting of aluminum oxide ("alumina", also Al₂O₃), aluminum nitride, silicon nitride, silicate-based materials and mixtures of two or more thereof. In an example embodiment, for applications requiring high strength, for example, the substrate may further include zirconia (ZrO₂). In an example embodiment, the ceramic insulating substrate is aluminum oxide. In an example embodiment, the ceramic insulating substrate consists essentially of aluminum oxide. In an example embodiment, the ceramic insulating substrate is aluminum oxide and the rare earth compound is a trivalent rare earth oxide. In another example embodiment, the ceramic insulating substrate is aluminum nitride and the corrosion-resistant non-porous layer is a rare earth silicate.

In an example embodiment, the corrosion-resistant non-porous layer is adhered to the ceramic insulating substrate, and the corrosion-resistant non-porous layer has: a porosity of at most 1%; an adhesion strength of at least 20 MPa; and, a thickness of at least 50 µm. In another example embodiment, the corrosion-resistant non-porous layer is adhered to the ceramic insulating substrate, and the corrosion-resistant non-porous layer has: a porosity of at most 0.5%; an adhesion strength of at least 30 MPa; a thickness of at least 100 µm; and, an average grain size of at least about 300 nm and at most about 30 µm.

The corrosion-resistant component 100 may be a lid configured for releasable engagement with a plasma etch reactor. In an example embodiment, a corrosion-resistant component or lid has a loss tangent of less than 1 × 10⁻⁴. In an example embodiment, ceramic insulating substrate 110 and corrosion-resistant non-porous layer 120 are substantially transparent to radio-frequency (RF) energy. In an example embodiment, ceramic insulating substrate 110 and corrosion-resistant non-porous layer 120 are transparent to radio-frequency (RF) energy.

In an example aspect, corrosion-resistant component 150, as shown in FIG. 1B, includes at least one interposing layer 130, the at least one interposing layer 130 is ytterbium oxide (Yb₂O₃). In an example embodiment, the at least one interposing layer comprises conducting materials. In an example embodiment, the at least one interposing layer further comprises insulating materials.

In an example embodiment, the at least one interposing layer is adhered to both the corrosion-resistant non-porous layer and to the ceramic insulating substrate, and the corrosion-resistant non-porous layer has: a porosity of at most 1%; an adhesion strength of at least 20 MPa; and, a thickness of at least 50 µm. In another example embodiment, the at least one interposing layer is adhered to both the corrosion-resistant non-porous layer and to the ceramic insulating substrate, and the corrosion-resistant non-porous layer has: a porosity of at most 0.5%; an adhesion strength of at least 30 MPa; a thickness of at least 100 µm; and, an average grain size of at least about 300 nm and at most about 30 µm.

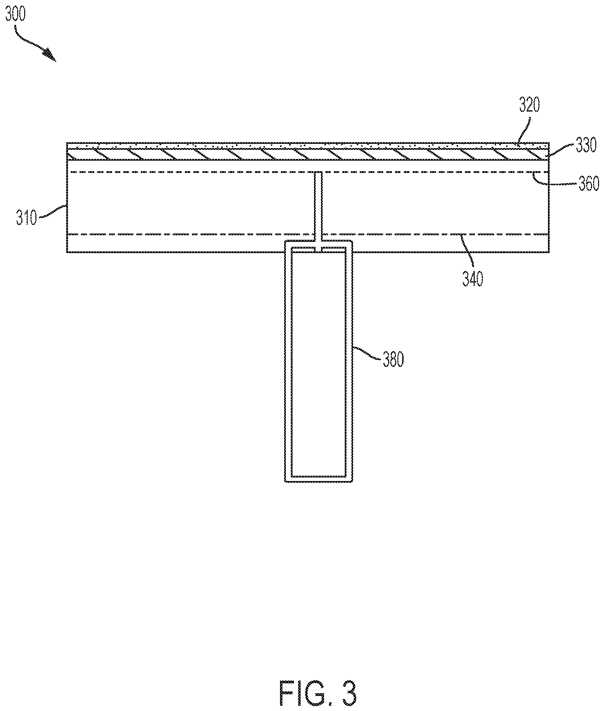

In an example embodiment, at least one interposing layer is either embedded in the ceramic insulating substrate 110 (see FIG. 3, layers 340, 360), or between and adhered to both the substrate and the corrosion-resistant non-porous layer 120 (see FIG. 1B). A rare earth oxide suitable as an at least one interposing layer is ytterbium oxide (Yb₂O₃). In another example embodiment, the interposing layer comprises conducting materials, which can optionally further comprise insulating materials. With regard to the conducting materials, for most applications direct current (DC) or low frequency, for example less than 100 MHz, conductivity is required. Conducting metal layers are useful as actively driven electrodes or as a passive RF shield. The insulating materials are generally selected from the group consisting of alumina, aluminum nitride, silicon nitride, aluminates, silicates, and mixtures of two or more thereof, although any material compatible with the processing of the part and the metals in the layer could be also used; the reasons to add materials to the conducting layer can include obtaining better thermal expansion match to the rest of the part and improving the adhesion between the layer and the rest of the part. In the case where conducting materials are used, the layer will usually have large openings in it to allow RF energy to pass through. In other words, in an example embodiment, an interposing layer such as a conductive layer is noncontinuous. In one embodiment of the corrosion-resistant component the substrate and the corrosion-resistant non-porous layer are substantially transparent to radio-frequency (RF) energy.

The present disclosure also includes, and prior to heat treatment, a green laminate configured for use with a semiconductor processing reactor comprises a first layer of green sinterable material and a second layer of green sinterable material including a rare earth compound. The first layer of green sinterable material is selected from the group consisting of aluminum oxide, aluminum nitride, silicon nitride, silicate-based materials, and mixtures of two or more thereof. The second layer of green sinterable material comprises a trivalent rare earth oxide. The second layer may comprise a rare earth compound selected from the group consisting of yttrium oxide (Y₂O₃), yttrium silicates, yttrium fluorides, yttrium oxyfluorides, yttrium aluminates, nitrides, complex nitride compounds, and combinations of two or more thereof. Upon heat treatment of the laminate, the second layer has a porosity of at most 1% and an average grain size of at least 100 nm and at most 100 µm. It may be that upon heat treatment of the laminate, the second layer has a porosity of at most 0.5%. It may be that upon heat treatment of the laminate, the average grain size of the second layer is at least 300 nm and at most 30 µm.

The present disclosure also includes, a green laminate further including at least one interposing layer between the first and second layers, wherein the interposing layer comprises green sinterable material selected from the group consisting of rare earth oxides, rare earth silicates, rare earth aluminates, and mixtures of two or more thereof. It may be that the green laminate further includes at least one interposing layer wherein the at least one interposing layer comprises conducting materials. It may be that the green laminate further includes at least one interposing layer wherein the at least one interposing layer comprises insulating materials. The heat treatment for the green laminate is selected from the group consisting of hot pressing and hot isostatic pressing. After heat treatment, the heat treated or sintered laminate including interposing layer(s) has an adhesion strength of at least 15 MPa, or at least 20 MPa, or at least 25 MPa, or at least 30 MPa, or at least 35 MPa, or at least 40 MPa.

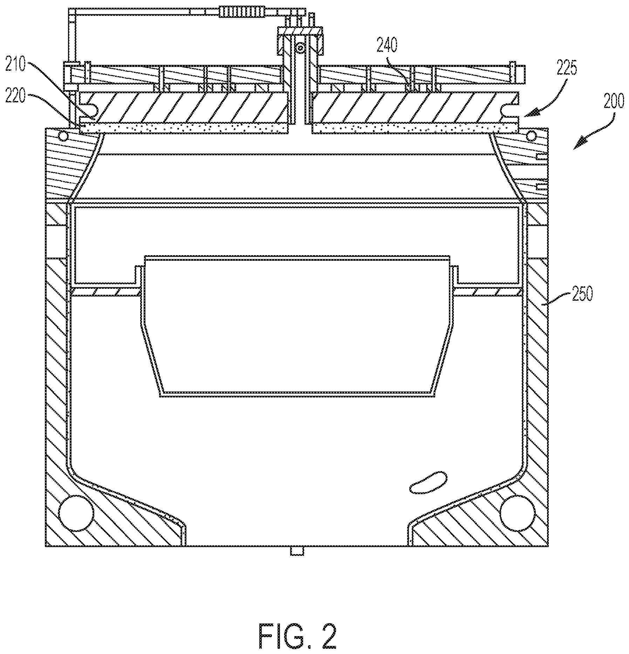

Figure 2 illustrates an assembly configured for use in plasma etching semiconductor wafers. Plasma etch reactor assembly 200 includes plasma etch reactor 250. Alternating magnetic fields generated by induction coils 240 extend through lid 225, creating electric fields inside reactor 250 directly under lid 225, which in turn create the etch plasma. Corrosion-resistant lid 225 is configured for releasable engagement with plasma etch reactor 250. Lid 225 includes a corrosion-resistant ceramic insulating substrate 210 having an inner surface and an outer surface; and, further includes corrosion-resistant non-porous layer 220, which is adjacent to the inner surface of substrate 210. Corrosion-resistant non-porous layer 220, having inner and outer planar surfaces, is positioned so that the inner planar surface of layer 220 faces the interior of reactor 250. Optionally, interposing layer(s) (example layer 130 as shown in FIG. 1B) are situated between substrate 210 and corrosion-resistant non-porous layer 220. In an example embodiment, layer 220 comprising a rare earth compound, wherein the non-porous layer is adhered to the corrosion-resistant substrate and has 1) an adhesion strength of ≥15 MPa, preferably >_20 MPa or ≥25 MPa or ≥30 MPa or ≥35 MPa or ≥40 MPa, 2) a thickness of ≥50 µm, preferably ≥100 µm or ≥150 µm or ≥200 µm or ≥250 µm or ≥300 µm; alternately a thickness in the range of about 50 to about 500 µm, preferably about 100 to about 400 µm, more preferably about 150 to about 300 µm, and 3) a porosity of ≤1% or ≤9% or ≤0.8% or ≤0.7% or ≤0.6% or ≤0.5% or ≤0.4% or ≤0.3% or ≤0.2% or ≤0.1%. In an example embodiment, layer 220 includes at least 15% by weight based on total weight of layer of a rare earth compound. In example embodiment, layer 220 includes an adhesion strength of at least 20 MPa; a porosity of at most 1%; a microstructure substantially devoid of microcracks and fissures and an average grain size of at least 100 nm and at most 100 µm; and, a layer thickness of at least 50 µm. In another example embodiment, the grain size is at least 300 nm and at most 30 µm.

In an example, lid 225 of the assembly includes layer 220, wherein the rare earth compound is selected from the group consisting of yttrium oxide (Y₂O₃), yttrium silicates, yttrium fluorides, yttrium oxyfluorides, yttrium aluminates, nitrides, complex nitride compounds and combinations of two or more thereof. It may be that the assembly includes the corrosion-resistant ceramic insulating substrate 210, wherein the substrate is selected from the group consisting of aluminum oxide, aluminum nitride, silicon nitride, silicate-based materials and mixtures of two or more thereof.

The assembly further comprises an interposing layer embedded in the substrate, or an interposing layer between and adhered to both the corrosion-resistant substrate and the non-porous layer. In an example, the interposing layer may serve one or more functions, for example, to promote adhesion between the non-porous layer and the substrate, to prevent an adverse reaction between the non-porous layer and the substrate, and/or to provide some electrical function for the assembly. In other example, for applications involving very high electric fields as required for particular lids, high electrical resistivity is desirable to prevent losses affecting processing, and therefore, an interposing layer such as ytterbium oxide (Yb₂O₃) can be beneficial.

The interposing layer is ytterbium oxide (Yb₂O₃). Preferably the corrosion-resistant lid of the assembly is substantially transparent to radio-frequency (RF) energy. The assembly, including the corrosion-resistant lid, is preferably resistant to the plasma etching treatment employed in semiconductor processing. Thus, the corrosion-resistant substrate and the corrosion-resistant non-porous layer of corrosion-resistant lid of the assembly are resistant to the plasma etching treatment employed in semiconductor processing.

Also disclosed is a high temperature corrosion-resistant wafer heater. FIG. 3 illustrates a cross-sectional schematic view of wafer heater apparatus 300. The wafer (not shown) sits on the outermost layer (320) of insulating ceramic disk 310 having heating elements 340 embedded therein and also, optionally, metal RF shield 360. In an exampleinsulating ceramic 310, from which these heaters are made, is aluminum nitride. In other example, alumina or silicon nitride is useful as ceramic insulating substrate 310. During operation, the heater is sometimes cleaned with fluorine-containing gas. If the temperature of the heater exceeds about 500°C, then the heater itself may be attacked by the fluorine thus making a corrosion-resistant protective layer included onto the 'hot' parts necessary. In an example, insulating ceramic 310 includes corrosion-resistant non-porous layer 320 and interposing layer 330 therebetween. Corrosion-resistant non-porous layer 320 includes an outer surface for holding the wafer (not shown). Of particular importance is that the region of the rare earth compound containing layer directly under the wafer, in other words corrosion-resistant non-porous layer 320, be dense. Otherwise particles from the heater would tend to be shed onto the underside of the wafer. These shed particles could migrate to the top side of the wafer in a subsequent step, which would in turn result in defects in the patterns on the wafer. The sides, bottom and coverage on the stalk or supporting disk 380 of the wafer heater are less critical, as there is no direct path for particles to migrate to the wafer. A plasma spray coating suffices to prevent against contamination for these other regions.

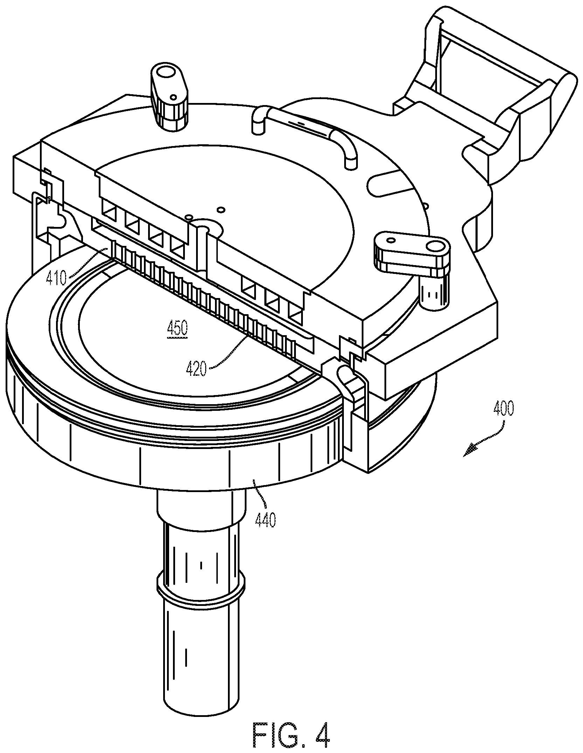

FIG. 4 illustrates a chemical vapor deposition reactor assembly including a wafer heater. Chemical vapor deposition (CVD) reactor assembly 400 includes showerhead 410 and heater 440. Reactive gases flow through showerhead 410, which is protected by corrosion-resistant non-porous layer 420, onto wafer 450, where a deposit is formed. The temperature of the wafer is maintained and kept uniform by heater 440, which may also have a non-porous corrosion-resistant layer on it (as shown in FIG. 3) to protect it during cleaning. Showerhead 410 may further include interposing or embedded layers, such as an electrode, within to assist the generation of a plasma to promote chemical reactions.

Assembly 400 is configured for use in fabricating semiconductor chips. Assembly 400 includes corrosion-resistant components (i) wafer heater 440, shown in FIG. 3 as wafer heater 300 in more detail), and/or (ii) showerhead 410. It may be that the deposition reactor is configured for in-situ cleaning with halogen gases and a corrosion-resistant component. Each corrosion-resistant component includes a ceramic insulating substrate; and, a corrosion-resistant non-porous layer of a composition comprising at least 15% by weight of a rare earth compound based on total weight of layer. In an example embodiment, the rare earth compound is a trivalent oxide. In another example embodiment, the rare earth compound is selected from the group consisting of yttrium oxide (Y₂O₃), yttrium silicates, yttrium fluorides, yttrium oxyfluorides, yttrium aluminates, nitrides, complex nitride compounds and combinations of two or more thereof. In an example embodiment, the rare earth compound is yttrium oxide (Y₂O₃). In an example embodiment, the ceramic insulating substrate is selected from the group consisting of aluminum oxide, aluminum nitride, silicon nitride, silicate-based materials, and mixtures of two or more thereof. In an example embodiment the corrosion-resistant component further includes at least interposing layer between the substrate and the corrosion-resistant non-porous layer. The interposing layer is ytterbium oxide (Yb₂O₃). In an example embodiment, the substrate further includes at least one additional interposing conductive layer embedded therein, the conductive layer having a sheet resistivity of at most 10 Megaohm-cm, which may also be written as 10 megohm-cm interchangeably herein.

An assembly configured for use in fabricating semiconductor chips, the assembly comprising a reactor and a corrosion-resistant component. The corrosion-resistant component includes a ceramic insulating substrate and a corrosion-resistant non-porous layer associated with the ceramic insulating substrate. In an example embodiment, the corrosion-resistant non-porous layer has a composition comprising at least 15% by weight of a rare earth compound based on total weight of the corrosion-resistant non-porous layer. In an example embodiment, the corrosion-resistant non-porous layer is characterized by a microstructure substantially devoid of microcracks and fissures, and having: a thickness of at least 50 µm; a porosity of at most 1%; and, an average grain size of at least 100 nm and at most 100 µm.

In an example embodiment, the ceramic insulating substrate of the assembly is selected from the group consisting of aluminum oxide, aluminum nitride, silicon nitride, silicate-based materials and mixtures of two or more thereof. In an example embodiment, the rare earth compound of the assembly is selected from the group consisting of yttrium oxide (Y₂O₃), yttrium silicates, yttrium fluorides, yttrium oxyfluorides, yttrium aluminates, nitrides, complex nitride compounds, and combinations of two or more thereof. In an example embodiment, the corrosion-resistant non-porous layer of the assembly is adhered to the ceramic insulating substrate and has an adhesion strength of at least 20 MPa. In another example embodiment, the corrosion-resistant non-porous layer has a thickness of at least 100 µm; a porosity of at most 0.5%; an adhesion strength of at least 30 MPa; and, an average grain size of at least about 300 nm and at most about 30 µm.

In an example embodiment, the assembly further comprises at least one interposing layer embedded in the ceramic insulating substrate, or layered between the ceramic insulating substrate and the corrosion-resistant non-porous layer. The at least one interposing layer is ytterbium oxide (Yb₂O₃). In an example embodiment, the at least one interposing layer comprises conducting materials that have a good coefficient of thermal expansion match with the ceramic insulating substrate and the corrosion-resistant non-porous layer. Thermal expansion mismatches can be considered close if the difference in thermal expansion coefficients is at most 4 × 10⁻⁶ /K relative to the coefficients for the ceramic insulating substrate and the corrosion-resistant non-porous layer. In an example embodiment, the at least one interposing layer is chosen to be a material having a thermal expansion coefficient difference of at most at most 4 × 10⁻⁶ /K relative to the coefficients for the ceramic insulating substrate and the corrosion-resistant non-porous layer. In an example embodiment, the at least one interposing layer further comprises insulating materials. The at least one interposing layer is ytterbium oxide (Yb₂O₃).

It may be that the reactor is a plasma etch reactor configured for plasma etching and the corrosion-resistant component is a lid configured for releasable engagement with the plasma etch reactor; and, wherein the lid has a loss tangent of less than 1 × 10⁻⁴ and is substantially transparent to radio-frequency (RF) energy. It may be that the reactor is a deposition reactor configured for in-situ cleaning with halogen gases and the corrosion-resistant component is a heater.It may be that the ceramic insulating substrate further includes at least one interposing conductive layer embedded therein, the conductive layer having a sheet resistivity of at most 10 Megaohm-cm. It may be that the reactor is a deposition reactor configured for in-situ cleaning with halogen gases and the corrosion-resistant component is a showerhead.

Another aspect is directed to a method for preparing a corrosion-resistant component for use with a reactor. The method includes the steps as follows: a) laying up a thinner layer of a sinterable powder composition comprising at least 15% by weight based on total weight of the thinner layer of a rare earth compound, and a thicker layer of sinterable substrate material to form a pre-laminate (also referred to herein as `green laminate'); and, b) heat treating the pre-laminate to form a corrosion-resistant laminate. The terms "thinner" versus "thicker" indicate that the thinner powder layer is less than 50% of the thicker powder layer in the pressing direction. Heat treating is selected from the group consisting of hot pressing and hot isostatic pressing.

In an example embodiment of the method, the sinterable substrate material is selected from the group consisting of aluminum oxide, aluminum nitride, silicon nitride, silicate-based materials, and mixtures of two or more thereof. In an example embodiment of the method, the rare earth compound is a tri-valent rare earth oxide. In an example embodiment of the method, the rare earth compound is selected from the group consisting of yttrium oxide (Y₂O₃), yttrium silicates, yttrium fluorides, yttrium oxyfluorides, yttrium aluminates, nitrides, complex nitride compounds and combinations of two or more thereof. In an example embodiment of the method, the amount of rare earth compound is about 15 to 100 wt%, or about 20 to about 90 wt%, or about 25 to about 80 wt%. In an example embodiment, the rare earth compound is Y₃Si₃O₁₀F. In an example embodiment of the method, the sinterable substrate material is aluminum oxide and the rare earth compound is a trivalent rare earth oxide. In another example embodiment of the method, the sinterable substrate material is aluminum nitride and the corrosion-resistant non-porous layer is a rare earth silicate. In an example embodiment of the method, the corrosion-resistant component is a lid configured for releasable engagement with a plasma etch reactor. In an example embodiment of the method, the lid has a loss tangent of less than 1 × 10⁻³. In another example embodiment of the method, the lid has a loss tangent of less than 1 × 10⁻⁴. In an example embodiment of the method, the corrosion-resistant component is substantially transparent to radio-frequency (RF) energy.

The method further comprises laying up at least one additional sinterable powder composition layer interposed between the rare earth compound thinner layer and the substrate material thicker layer, prior to heat treatment. The at least one additional sinterable powder composition comprises ytterbium oxide (Yb₂O₃), and optionally molybdenum (Mo), tungsten (W), niobium (Nb), and compounds like molybdenum disilicide (MoSi₂), tungsten carbide (WC), tungsten disilicide (WSi₂), titanium carbide (TiC), titanium nitride (TiN), and other such conducting materials and compounds that show metallic behavior and have a good coefficient of thermal expansion match to the ceramic insulating substrate and the corrosion-resistant non-porous layer, and mixtures of two or more thereof. The at least one additional sinterable powder composition is ytterbium oxide (Yb₂O₃). In an example embodiment, the method includes at least one additional sinterable powder composition comprises conducting materials. In an example embodiment, the method includes at least one additional sinterable powder composition comprises conducting metals. In an example embodiment, the method includes the at least one additional sinterable powder composition further comprises insulating materials. In another example embodiment, the method includes the at least one additional sinterable powder composition further comprises an insulating material selected from the group consisting of alumina, aluminum nitride, silicon nitride, silicates, and mixtures of two or more thereof.

It may be that the semiconductor processing reactor is a deposition reactor configured for in-situ cleaning with halogen gases and the corrosion-resistant component is a heater. In an example embodiment of the method, the sinterable substrate material further includes at least one interposing conductive layer embedded therein, the conductive layer having a sheet resistivity of at most 10 Megaohm-cm. In another example embodiment of the method, the semiconductor processing reactor is a deposition reactor configured for in-situ cleaning with halogen gases and the corrosion-resistant component is a showerhead.

Also disclosed is a corrosion-resistant component configured for use with a semiconductor processing reactor, similarly as shown in FIG. 1A, which is white. The corrosion-resistant component 100 comprises: a) a ceramic insulating substrate 110; and, b) a white corrosion-resistant non-porous outer layer 120 associated with the ceramic insulating substrate, the white corrosion-resistant non-porous outer layer having a thickness of at least 50 µm, a porosity of at most 1%, and a composition comprising at least 15% by weight of a rare earth compound based on total weight of the corrosion-resistant non-porous layer; and, c) an L* value of at least 90 as measured on a planar surface of the white corrosion-resistant non-porous outer layer. It may be that component 100 comprises an L* value of at least 92 as measured on a planar surface of the white corrosion-resistant non-porous outer layer.It may be that component 100 comprises an L* value of at least 94 as measured on a planar surface of the white corrosion-resistant non-porous outer layer. The ceramic insulating substrate 110 is selected from the group consisting of aluminum oxide, aluminum nitride, silicon nitride, silicate-based materials and mixtures of two or more thereof. The rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof. It may be that the rare earth compound is yttrium oxide (Y₂O₃). It may be that the white corrosion-resistant non-porous outer layer has a thickness of at least 100 µm, a porosity of at most 0.5%, and an average grain size of at most 50 µm. It may be that the white corrosion-resistant non-porous layer associated with the ceramic insulating substrate is adhered to the substrate. It may be that the corrosion-resistant non-porous layer is adhered directly to the substrate. It may be that the white corrosion-resistant non-porous layer is adhered indirectly to the substrate, for example with interposing layers therebetween.

The white corrosion-resistant non-porous outer layer may further comprise a sintering aid added to the rare-earth compound in the range from about 300 ppm to about 20% by weight based upon total weight of the rare-earth compound. The sintering aid added to the rare-earth compound may be in the range from about 0.5% by weight to about 5% by weight based upon total weight of the rare-earth compound. The sintering aid may be at least one material chosen from ZrO₂, HfO₂, and CeO₂. The sintering aid may be at least one material chosen from ZrO₂, HfO₂, CeO₂, and mixtures of two or more thereof. The sintering aid may be ZrO₂ and is added to the rare-earth compound in the amount of 1% by weight based upon total weight of the rare-earth compound.

In an example aspect, similarly as shown in FIG. 1B, corrosion-resistant component 150 further comprises at least one interposing layer 130 embedded in the ceramic insulating substrate, or layered between the ceramic insulating substrate 110 and the white corrosion-resistant non-porous outer layer 120, wherein the at least one interposing layer is at least one material chosen from rare earth oxides, rare earth silicates, rare earth aluminates, and mixtures of two or more thereof. The at least one interposing layer 130 is ytterbium oxide (Yb₂O₃). In other example embodiments, the at least one interposing layer 130 further comprises conducting materials. An assembly configured for use in fabricating semiconductor chips is also disclosed, the assembly comprising: a reactor; and, the corrosion-resistant component having a white corrosion-resistant non-porous outer layer as described above. It may be that the reactor is a plasma etch reactor configured for plasma etching and the corrosion-resistant component is a lid configured for releasable engagement with the plasma etch reactor; and, wherein the lid has a loss tangent of less than 1 × 10⁻⁴. It may be that the reactor is a deposition reactor configured for in-situ cleaning with halogen gases and the corrosion-resistant component is a heater.

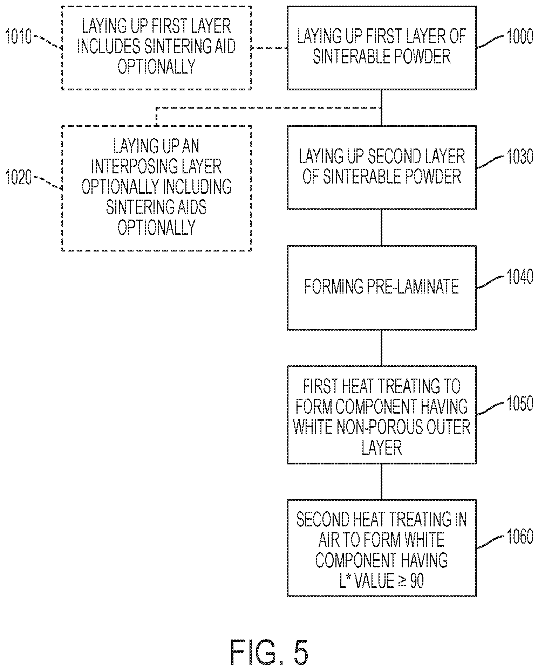

As shown in the flow diagram of FIG. 5, a method for preparing a white corrosion-resistant component for use with a semiconductor processing reactor is provided. The method comprises the following steps. Step 1000 includes laying up a first layer of a sinterable powder composition comprising at least 15% by weight based on total weight of the first layer of a rare earth compound. Step 1030 includes laying up a second layer of sinterable substrate material. Steps 1000 and 1030 together form a pre-laminate in step 1040. The second layer of sinterable substrate material is selected from the group consisting of aluminum oxide, aluminum nitride, silicon nitride, silicate-based materials and mixtures of two or more thereof. The rare earth compound is selected from the group consisting of yttrium oxide (Y₂O₃), yttrium silicates, yttrium fluorides, yttrium oxyfluorides, yttrium aluminates, nitrides, complex nitride compounds, and combinations of two or more thereof.

The first layer of step 1000 is less than 50% as thick as the second layer of step 1030. Step 1050 includes heat treating the pre-laminate to form a corrosion-resistant component including a white corrosion-resistant non-porous outer layer. The white corrosion-resistant non-porous outer layer has a thickness of at least 50 µm and a porosity of at most 1%. The white corrosion-resistant non-porous outer layer is now sintered and associated with the heat treated substrate material, also now sintered, to form a corrosion-resistant laminate having a white non-porous outer layer. The heat treatment of step 1050 includes heat treatment techniques as known in the art for sintering including non-limiting examples of hot pressing and hot isostatic pressing. Step 1050 typically includes a heat treatment in an inert atmosphere, such as Ar for example, or in a vacuum. The temperature and time of the heat treatment as in step 1050 ranges up to about 1500 °C for up to 30 h.

The corrosion-resistant laminate or component formed in step 1050, is then further heat treated in subsequent heat treatment step 1060. Step 1060 includes heat treating the corrosion-resistant laminate in an oxygen-containing gas or air. In an example aspect, the temperature of the second heat treatment ranges from at least 800 °C to at most 1500 °C and the time ranges from at least 0.5 h to at most 48 h. In an example aspect, the heat treatment temperature of step 1060 is from at least 1000 °C to at most 1400 °C, or from at least 1100 °C to at most 1300 °C, or from at least 1150 °C to at most 1250 °C. In an example aspect, the heat treatment temperature of step 1060 is about 1200 °C. In an example aspect, the heat treatment time duration of step 1060 ranges from at least 1 h to at most 24 h, or from at least 2 h to at most 12 h, or from at least 3 h to at most 6 h. In an example aspect, the heat treatment time duration of step 1060 is about 4 h. This second heat treatment of step 1060 forms a white corrosion-resistant component. The white corrosion-resistant component has an L* value of at least 90 as measured on a planar surface of the white corrosion-resistant non-porous outer layer after step 1060. In a preferred embodiment, the heat treatment of step 1060 is at 1200 °C for 4 h. In another example aspect, the white corrosion-resistant component has an L* value of at least 92 as measured on a planar surface of the corrosion-resistant non-porous outer layer. In another example aspect, the white corrosion-resistant component has an L* value of at least 94 as measured on a planar surface of the corrosion-resistant non-porous outer layer.

Step 1000 further includes step 1010 directed to laying up the first layer of sinterable powder composition comprising at least 15% by weight based on total weight of the first layer of a rare earth compound to further comprise a sintering aid added to the rare-earth compound in the range from about 300 ppm to about 20% by weight based upon total weight of the rare-earth compound. In another example embodiment, step 1010 includes wherein the sintering aid is at least one material chosen from ZrO₂, HfO₂, and CeO₂. In another example embodiment, step 1010 includes the sintering aid added is in the amount of at least 0.5% by weight and at most 5% by weight based upon total weight of the rare-earth compound. In another example embodiment, step 1010 includes wherein the sintering aid added is ZrO₂ in the amount of about 1% by weight based upon total weight of the rare-earth compound.

Step 1020, falling sequentially between step 1000 and step 1030, includes laying up at least one interposing layer of sinterable powder layered between the first layer and the second layer, wherein the at least one interposing layer of sinterable powder is at least one material chosen from rare earth oxides, rare earth silicates, rare earth aluminates, and mixtures of two or more thereof. Step 1030 optionally includes at least one sintering aid added to the interposing layer. In an example embodiment, the sintering aid added to the interposing layer is at least one material chosen from ZrO₂, HfO₂, and CeO₂.

The disclosure also includes a corrosion-resistant component configured for use with a semiconductor processing reactor. The corrosion-resistant component comprises: a) a ceramic insulating substrate; and, b) a white corrosion-resistant non-porous outer layer associated with the ceramic insulating substrate, the white corrosion-resistant non-porous outer layer having a thickness of at least 50 µm, a porosity of at most 1%, and a composition comprising at least 15% by weight of a rare earth compound based on total weight of the corrosion-resistant non-porous layer and a sintering aid added to the rare-earth compound in the range from about 300 ppm to about 20% by weight based upon total weight of the rare-earth compound, wherein the sintering aid is at least one material chosen from ZrO₂, HfO₂, and CeO₂; c) at least one interposing layer embedded in the ceramic insulating substrate, or layered between the ceramic insulating substrate and the corrosion-resistant non-porous layer, wherein the at least one interposing layer is at least one material chosen from rare earth oxides, rare earth silicates, rare earth aluminates, and mixtures of two or more thereof; and, d) an L* value of at least 90 as measured on a planar surface of the white corrosion-resistant non-porous outer layer. It may be that the planar surface for measurement is smooth and/or polished.

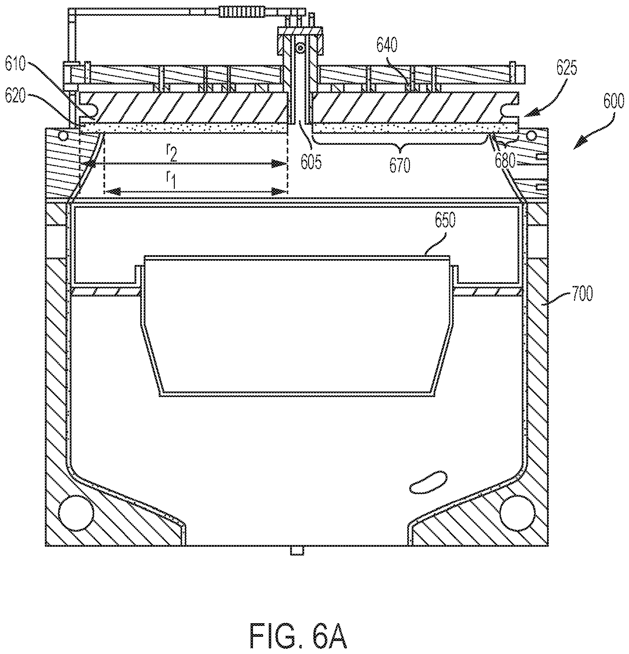

FIG. 6A illustrates an assembly configured for use in plasma etching semiconductor wafers. Plasma etch reactor assembly 600 includes plasma etch reactor 700. Alternating magnetic fields generated by induction coils 640 extend through lid 625, creating electric fields inside reactor 700 directly under lid 625, which in turn create the etch plasma. Corrosion-resistant lid 625 is configured for releasable engagement with plasma etch reactor 700. Lid 625 includes a corrosion-resistant ceramic insulating substrate 610 having an inner surface and an outer surface; and, further includes white corrosion-resistant non-porous layer 620, which is adjacent to the inner surface of substrate 610. In an example aspect, substrate 610 is also white. Corrosion-resistant non-porous layer 620, having inner and outer planar surfaces, is positioned so that the inner planar surface of layer 620 faces the interior of reactor 700. Component or lid 625 is disk-shaped and includes an axial void 605 at the center configured to fit into assembly 600. Axial void 605 may also be referred to interchangeably herein as center 605.

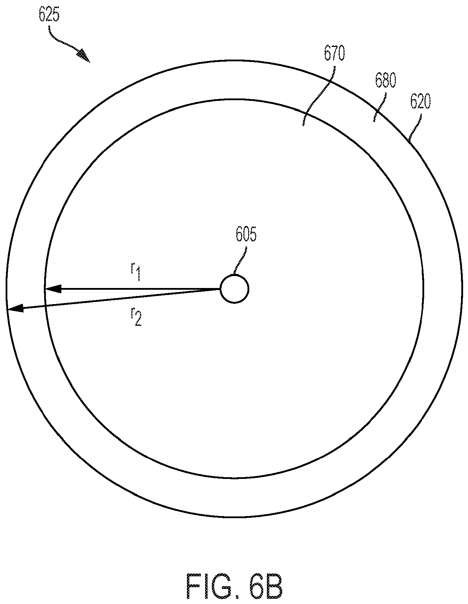

FIG. 6B illustrates a top view of lid or component 625 with a view onto the inner planar surface of white corrosion-resistant non-porous layer 620. The inner planar surface of 620, in the non-limiting example shown in top view FIG. 6B for the disk-shaped component, is circular and includes a central region 670 extending to a first radial distance r₁ from center 605. The central region 670 of the inner planar surface of layer 620 corresponds to the area of component 625 that is exposed to the interior of reactor 700 and is thus exposed to aggressive processes. Aggressive processes may mean plasma etching, as in this non-limiting example. For other components of the present disclosure, aggressive processes may mean plasma etching or deposition or both. An outer region 680, disposed outside of central region 670, extends from radial distance r₁ to a second radial distance r₂ from center 605. Outer region 680, as shown in FIGs. 6A and 6B, may interchangeably be referred to herein as outer rim 680. Outer region 680 corresponds to the area of component 625 that is not necessarily exposed to aggressive processes and extends radially outward past an o-ring for sealing reactor 700. In an example aspect, L*a*b* measurements are collected for the central region 670 of the inner planar surface of white corrosion-resistant non-porous layer 620 of component 625. The central region 670 may also be referred to herein as planar surface for L*a*b* measurement purposes. In an example aspect, central region 670 is a polished, planar surface.

### EXAMPLES

For all examples, and in view of the need to minimize contamination, a total concentration of undesirable elements in raw materials used is at most 1 at%.

### Example 1 (not forming part of the invention)

Two disks (S1 and S12) made from an alumina-yttria laminate were manufactured as follows. High purity chemically precipitated yttrium oxide powder from AMR Corp. was attrition milled in water to particle size d90 <1 µm. The slurry was then freeze dried and sieved through a 150 µm mesh.

Spray dried alumina powder of approximate composition 0.25 wt% SiO₂, 0.05 wt% Na₂O, 0.12 wt% MgO, 0.12 wt% CaO, balance Al₂O₃ was heated in air at 800°C for 8 hours to remove binder from the spray dried powder. This powder is referred to as CoorsTek 99512.

The alumina powder was cold pressed in a 6-inch diameter die to a pressure of 440 psi and a total thickness of about 1 inch. A layer of the yttria powder described above was then added on top of the alumina and cold pressed to 440 psi again. The yttria layer was about 2000 µm thick at this point.

For the second laminate (S12), the process was repeated except that a layer of ytterbium oxide (Yb₂O₃) powder about 1000 µm was interposed between the yttria layer and the alumina layer.

The cold pressed laminate was transferred to a hot press mold assembly, consisting of the stack arrangement depicted below in Table 1.

**Table 1. Stack arrangement for Example 1 Hot Pressing.**

| |
|---|
| TOP |
| 1-inch Graphite Spacer |
| 1 Part |
| 1-inch Graphite Spacer |
| 3-inch Graphite Spacer |
| BOTTOM |

All spacers and parts were 6 inches in diameter. The Die Barrel was 7 inches inside diameter (ID) and 15 inches outside diameter (OD). The assembly was hot pressed according to the temperature schedule shown in Table 2.

**Table 2. Temperature Cycle during Hot Pressing.**

| Temperature, °C | | | | |
|---|---|---|---|---|
| Time (min) | Ramp (°C /min) | Setpoint, °C | Soak (min) | Atmos. |
| 0.0 | | 20 | 1 | Ar |
| 1.0 | 5 | 1050 | | Ar |
| 207.0 | | 1050 | 10 | Ar |
| 217.0 | 5 | 1400 | | Ar |
| 287.0 | | 1400 | 60 | Ar |
| 347.0 | 3 | 1550 | | Ar |
| 397.0 | | 1550 | 60 | Ar |
| 457.0 | 5 | 1050 | | Ar |
| 557.0 | | 1050 | 10 | Ar |
| 567.0 | 5 | 300 | | Ar |
| 717.0 | 5 | 20 | | Ar |
| 773.0 | | 20 | 1 | Ar |

| | | | | |
|---|---|---|---|---|
| Ar = under argon atmosphere | | | | |

Pressure was applied according to the cycle shown in Table 3.

**Table 3. Pressure Cycle during Hot Pressing.**

| | | | Time | | |
|---|---|---|---|---|---|
| Pressure | Ramp | Soak | total | segment | |
| Psi | (min) | (min) | min | h | m |
| 6000 | 0 | | 0 | 0 | 0 |
| 6000 | | 287 | 287 | 4 | 47 |
| 7500 | 60 | | 347 | 1 | 0 |
| 7500 | | 102 | 449 | 1 | 42 |
| 6000 | 105 | | 554 | 1 | 45 |
| 6000 | | 208 | 762 | 3 | 28 |

Gray dense yttria-alumina laminates emerged from the hot press operation. The grain size of the alumina as measured by the ASTM-E112 method was 1.7 µm. The carbon content was 640 ppm. The loss tangent of S1 measured at 5 GHz was 9.1 × 10⁻⁵. Porosity was measured by image analysis of a polished section, polished according to the following scheme (polishing supplies provided by Struers, Inc.):
60 µm diamond: as needed to flatten the surface
15 µm diamond, fixed abrasive pad: 2 min
9 µm diamond, Largo (plastic) pad: 8 min
3 µm diamond, DAC (nylon) pad: 6 min
1 µm diamond, napped cloth: 3 min.

The porosity of S1 and S12 were found to be 0.24% and 0.72% respectively. The corrosion-resistant non-porous yttria layer was observed to substantially have no microcracks or fissures. Measuring from the sections, S1 and S12 had yttria layer thickness of 910 µm and 940 µm respectively. The ytterbium oxide layer thickness measured from the section was 520 µm. Adhesion strength as measured by a variant of ASTM C633 was found to be 30 MPa. As measured herein, adhesion strength is the force required to cause failure when tension is applied between the outermost layer and the substrate, irrespective of the presence or absence of interposing layers or of the location of the failure, provided that the failure is not confined exclusively to the substrate. The outermost layer being adhered to the substrate may include instances wherein at least one interposing layer is included and/or a reaction layer inherently resulting from sintering exists between the outermost layer and the substrate. For sample S1, a reaction layer having composition Y₃Al₅O₁₂ between the yttria layer and the alumina substrate was present. Darkness L* of the sample, measured on the yttria side with a Hunterlab MiniScan XE colorimeter using the CIE L*a*b* color scale, was 53.9.

### Example 2 (not forming part of the invention)

Two yttria-aluminate laminates were cold pressed as described for sample S1 in Example 1, except that one laminate (S4) used Grade APA alumina powder from Sasol and the other laminate (S5) used Grade AHPA alumina powder also from Sasol. The cold-pressed disks were hot pressed with the same stackup as shown in Table 4.

**Table 4. Stack arrangement for Example 2 Hot Pressing.**

| |
|---|
| TOP |
| 1-inch Graphite Spacer |
| 1 Part |
| 1-inch Graphite Spacer |
| 3-inch Graphite Spacer |
| 1 Part |
| 1-inch Graphite Spacer |
| 3-inch Graphite Spacer |
| BOTTOM |

The temperature and pressure cycles are shown in Tables 5 and 6.

**Table 5. Temperature Cycle during Example 2 Hot Pressing.**

| Temperature, °C | | | | |
|---|---|---|---|---|
| Time (min) | Ramp (/min) | Setpoint, °C | Soak (min) | Atmos. |
| 0.0 | | 20 | 1 | Ar |
| 1.0 | 5 | 1050 | | Ar |
| 207.0 | | 1050 | 10 | Ar |
| 217.0 | 5 | 1200 | | Ar |
| 247.0 | | 1200 | 60 | Ar |
| 307.0 | 3 | 1400 | | Ar |
| 373.7 | | 1400 | 60 | Ar |
| 433.7 | 5 | 1050 | | Ar |
| 503.7 | | 1050 | 10 | Ar |
| 513.7 | 5 | 300 | | Ar |
| 663.7 | 5 | 20 | | Ar |
| 719.7 | | 20 | 1 | Ar |

| | | | | |
|---|---|---|---|---|
| Ar = under argon atmosphere | | | | |

**Table 6. Pressure Cycle during Example 2 Hot Pressing.**

| | | | Time | | |
|---|---|---|---|---|---|
| Pressure | Ramp | Soak | total | segment | |
| Psi | (min) | (min) | min | h | m |
| 6000 | 0 | | 0 | 0 | 0 |
| 6000 | | 247 | 247 | 4 | 7 |
| 7500 | 60 | | 307 | 1 | 0 |
| 7500 | | 127 | 434 | 2 | 7 |
| 6000 | 80 | | 514 | 1 | 20 |
| 6000 | | 208 | 722 | 3 | 28 |

The grain sizes of the alumina as measured by the ASTM-E112 method were 0.76 µm (S4) and 0.92 µm (S5). The grain size of the yttria measured in the same way was found to be 0.4 µm. The loss tangent of S4 at 5 GHz was found to be 11 × 10⁻⁵, and that of S5 to be 15.7 × 10⁻⁵.

The porosity of both samples was measured by the method described in Example 1. S4 had a porosity of 0.50% and S5 of 0.69%. Substantially no microcracks or fissures were observed in the corrosion-resistant non-porous yttria layer. Adhesion strength as measured by ASTM C633 was found to be 20 MPa for S4 and 26 MPa for S5. As with sample S1, a reaction layer between the yttria layer and alumina substrate was present. Darkness L* of the sample, measured on the yttria side with a Hunterlab MiniScan XE colorimeter using the CIE L*a*b* color scale, was 49.7 for S4 and 66.1 for S5.

### Example 3 (not forming part of the invention)

Two yttria-alumina laminates were cold pressed as described in Example 2. One laminate (S6) used AHPA alumina powder from Sasol, and the other laminate (S7) used Baikowski TCPLS DBM alumina powder from Baikowski-Malakoff. Each laminate was placed between sheets of Mo foil.

The cold-pressed disks were hot pressed with the same stack configuration as in Example 2. The temperature and pressure cycles are shown in Tables 7 and 8.

**Table 7. Temperature Cycle during Example 3 Hot Pressing.**

| Temperature, °C | | | | |
|---|---|---|---|---|
| Time (min) | Ramp (/min) | Setpoint, °C | Soak (min) | Atmos. |
| 0.0 | | 20 | 1 | Ar |
| 1.0 | 5 | 1050 | | Ar |
| 207.0 | | 1050 | 10 | Ar |
| 217.0 | 3 | 1200 | | Ar |
| 267.0 | | 1200 | 1 | Ar |
| 268.0 | 3 | 1400 | | Ar |
| 334.7 | | 1400 | 60 | Ar |
| 394.7 | 5 | 1050 | | Ar |
| 464.7 | | 1050 | 10 | Ar |
| 474.7 | 5 | 300 | | Ar |
| 624.7 | 5 | 20 | | Ar |
| 680.7 | | 20 | 1 | Ar |

| | | | | |
|---|---|---|---|---|
| Ar = under argon atmosphere | | | | |

**Table 8. Pressure cycle during Example 3 Hot Pressing.**

| | | | Time | | |
|---|---|---|---|---|---|
| Pressure | Ramp | Soak | total | segment | |
| Psi | (min) | (min) | min | h | m |
| 6000 | 0 | | 0 | 0 | 0 |
| 6000 | | 217 | 217 | 3 | 37 |
| 7500 | 30 | | 247 | 0 | 30 |
| 7500 | | 148 | 395 | 2 | 28 |
| 6000 | 80 | | 475 | 1 | 20 |
| 6000 | | 208 | 683 | 3 | 28 |

The loss tangent of sample S6 was measured to be 4 × 10⁻⁵. L* was found to be 75.4 for S6 and 75.9 for S7. Adhesion strength for S6 was 24 MPa and 35 MPa for S7.

### Example 4 (not forming part of the invention)

Two yttria-alumina laminates were cold pressed as described for Sample S7 in Example 3. One laminate (S8) used AHPA alumina powder from Sasol with which about 0.5% AlF₃ had been dry mixed, and the other laminate (S9) used Baikowski SA-80 alumina powder from Baikowski-Malakoff (without AlF₃ additions). Each laminate was placed between sheets of molybdenum (Mo) foil.

Fluoride was added to S8 as a densification aid. The cold-pressed disks were hot pressed with the same stackup as in Example 2. The temperature cycle is shown in Table 9. The pressure cycle is same as for Table 6, previously shown.

**Table 9. Temperature cycle for Example 4 Hot Pressing.**

| Temperature, °C | | | | |
|---|---|---|---|---|
| Time (min) | Ramp (/min) | Setpoint, °C | Soak (min) | Atmos. |
| 0.0 | | 20 | 1 | Ar |
| 1.0 | 5 | 1050 | | Ar |
| 207.0 | | 1050 | 10 | Ar |
| 217.0 | 5 | 1200 | | Ar |
| 247.0 | | 1200 | 60 | Ar |
| 307.0 | 3 | 1400 | | Ar |
| 373.7 | | 1400 | 60 | Ar |
| 433.7 | 5 | 1050 | | Ar |
| 503.7 | | 1050 | 10 | Ar |
| 513.7 | 5 | 300 | | Ar |
| 663.7 | 5 | 20 | | Ar |
| 719.7 | | 20 | 1 | Ar |

| | | | | |
|---|---|---|---|---|
| Ar = under argon atmosphere | | | | |

The laminate made from the AHPA powder including AlF₃ additions was cracked in several places on removal and a porous interface between the yttria layer and the alumina layer was observed. The loss tangent of this sample (S8) was 2 × 10⁻⁵. The loss tangent of S9 was 4.6 × 10⁻⁵. L* was found to be 48.6 for S8 and 76.0 for S9. Adhesion strength for S8 was less than 5 MPa and was 39 MPa for S9.

### Example 5 (not forming part of the invention)

Two yttria-alumina laminates were cold pressed as described for sample S9 in Example 4, except that a layer of ytterbium oxide (Yb₂O₃) powder about 0.04" was interposed between the yttria layer and the alumina layer. Both laminates used the CoorsTek 995I2 powder described in Example 1. One laminate (S11) had one layer of 0.004" Mo foil placed on one side, while the other one (S10) did not.

The cold-pressed disks were hot pressed with the same stackup as in Example 2. The pressure and temperature cycles are the same as for example 4.

The loss tangent of S10 was found to be 15×10⁻⁵, and its porosity was measured to be 1%. Substantially no microcracks or fissures were observed in the corrosion-resistant non-porous yttria layer. The as-hot-pressed layer thickness of Y₂O₃ was 920 µm and the thickness of the Yb₂O₃ layer was 530 µm after hot pressing. L* was found to be 49.7 for S10. Adhesion strength for S10 was 28 MPa.

For S11, the as-hot-pressed layer thickness of Y₂O₃ was 700 µm and the thickness of the Yb₂O₃ layer was 450 µm after hot pressing.

### Example 6 (not forming part of the invention)

One yttria-alumina laminate (S43) was cold pressed as described in Example 5, except that the yttria and ytterbia powders were supplied by PIDC. The laminate used the APA powder from Sasol. Mo foil was placed on both sides of the laminate.

The cold-pressed disk was hot pressed with the same stackup as in Table 4 for Example 2. The temperature and pressure cycles are shown in Tables 10 and 11.

**Table 10. Temperature Cycle for Example 6 Hot Pressing.**

| Temperature, °C | | | | |
|---|---|---|---|---|
| Time (min) | Ramp (/min) | Setpoint, °C | Soak (min) | Atmos. |
| 0.0 | | 20 | 1 | Vac |
| 1.0 | 5 | 1050 | | Vac |
| 207.0 | | 1050 | 10 | Vac |
| 217.0 | 3 | 1200 | | Vac |
| 267.0 | | 1200 | 1 | Vac |
| 268.0 | 3 | 1550 | | Vac |
| 384.7 | | 1550 | 60 | Vac |
| 444.7 | 5 | 1050 | | Vac |
| 544.7 | | 1050 | 10 | Vac |
| 554.7 | 5 | 300 | | Vac |
| 704.7 | 5 | 20 | | Vac |
| 760.7 | | 20 | 1 | Vac |

**Table 11. Pressure Cycle for Example 6 Hot Pressing.**

| | | | Time | | |
|---|---|---|---|---|---|
| Pressure | Ramp | Soak | total | segment | |
| Psi | (min) | (min) | min | h | m |
| 0 | 0 | | | 0 | 0 |
| 0 | | 217 | 217 | 3 | 37 |
| 2000 | 30 | | 247 | 0 | 30 |
| 2000 | | 198 | 445 | 3 | 18 |
| 0 | 110 | | 555 | 1 | 50 |
| 0 | | 151 | 706 | 2 | |

The as-hot-pressed layer thickness of Y₂O₃ for S43 was 2950 µm and the thickness of the Yb₂O₃ layer was 525 µm after hot pressing.

### Example 7 (not forming part of the invention)

One yttria-alumina laminate (S50) was cold pressed as described in Example 6. The laminate used the APA powder from Sasol. Mo foil was placed on both sides of the laminate. The yttria powder was mixed with 1 wt% ZrO₂ before use.

The cold-pressed disk was hot pressed with the same stackup as in Table 4 for Example 2. The pressure and temperature cycles are the same as for Example 6. The loss tangent of S50 was found to be 2.39 × 10⁻⁵. The as-hot-pressed layer thickness of Y₂O₃ was 720 µm and the thickness of the Yb₂O₃ layer was 350 µm after hot pressing. The grain size of the yttrium oxide layer was estimated to be about 2 µm.

### Example 8 (not forming part of the invention)

Two yttria-alumina laminates were cold pressed as described in Example 7. One laminate (S54) used the APA powder by Sasol, along with PIDC yttria and a 40 µm thick ceramic tape of ytterbia, with the ytterbia powder also coming from PIDC. The second laminate (S55) used HPA alumina from Orbite Technologies, along with PIDC yttria and ytterbia. Both laminates had Mo foil on both faces.

The cold-pressed disks were hot pressed with the same stackup as in Table 4 for Example 2. The pressure and temperature cycles are the same as for Example 6. The loss tangent of S54 was found to be 3.93 × 10⁻⁵. The as-hot-pressed layer thickness of Y₂O₃ was 985 µm and the thickness of the Yb₂O₃ layer was 40 µm after hot pressing. For S55, the loss tangent was found to be 2.06 × 10⁻⁵. The as-hot-pressed layer thickness of Y₂O₃ was 1000 µm and the thickness of the Yb₂O₃ layer was 315 µm after hot pressing. The grain size of the yttrium oxide layers for S54 and S55 were determined to be about 5 to 20 µm.

### Example 9 (not forming part of the invention)

Two yttria-alumina laminates were cold pressed as described in Example 8. One laminate (S57) used the APA powder by Sasol, along with PIDC yttria mixed with 3 vol% yttrium oxyfluoride (YOF) and PIDC ytterbia. The second laminate (S58) APA powder by Sasol, PIDC ytterbia, and PIDC yttria mixed with 3 vol% Y₂Si₂O₇. Both laminates had Mo foil on both faces.

The cold-pressed disks were hot pressed with the same stackup as in Table 4 for Example 2. The pressure and temperature cycles are the same as for Example 6. The loss tangent of S57 was found to be 4.50 × 10⁻⁵. The as-hot-pressed layer thickness of Y₂O₃ was 1085 µm and the thickness of the Yb₂O₃ layer was 380 µm after hot pressing. The grain size of the yttrium oxide layer for S57 was determined to be about 50 µm. For S58, the loss tangent was found to be 7.73 × 10⁻⁵. The as-hot-pressed layer thickness of Y₂O₃ was 980 µm and the thickness of the Yb₂O₃ layer was 425 µm after hot pressing. The grain size of the yttrium oxide layer for S58 was determined to be about 5 to 10 µm.

### Example 10 (not forming part of the invention)

One laminate (S49) was cold pressed as described in Example 6. The laminate used the APA powder from Sasol as the alumina base and a blend of 77 wt% yttria, 15 wt% zirconia, and 8 wt% alumina as the top layer. Mo foil was placed on both sides of the laminate.

The cold-pressed disk was hot pressed with the same stackup as in Table 4 for Example 2. The pressure and temperature cycles are the same as for Example 6. The loss tangent of S49 was found to be 13.3 × 10⁻⁵. The as-hot-pressed layer thickness of blended layer was 1215 µm. Adhesion of the laminate was found to be 32 MPa. The average grain size of the yttria-rich grains of the non-porous layer was estimated to be about 2 µm. At least one second phase, namely alumina-rich grains of the composition Y₄Al₂O₉, was observed in the microstructure and this second phase is believed to contribute to increased strength of the layer.

A summary of properties for Examples 1 through 10 is included in Table 12.

Large 580 mm laminate disks were prepared as follows.

### Example 11 (not forming part of the invention)

Sample A was prepared by loading 29.5kg of alumina powder (APA) into a 580 mm diameter graphite die, followed by leveling and compacting with 100 kN of force. Then, 2.5 kg of Yb₂O₃ powder (PIDC) was loaded on top of the alumina layer, leveled and compacted with 100kN of force. Next, 4 kg of Y₂O₃ powder (PIDC) was loaded on top of the ytterbia layer, leveled and compacted with 100kN of force. The graphite dies of the hot press were separated from the charge by a layer of 0.02" Grafoil and then a layer of 0.005" molybdenum foil. The temperature and pressure cycles for hot pressing are shown in Table 13. Temperature ramps between the values indicated were approximately linear. Pressure increases were immediate.

**Table 13. Temperature & Pressure Cycle during Example 11 Hot Pressing.**

| Time (min) | Setpoint, °C | Pressure (psi) | Atmos. |
|---|---|---|---|
| 0.0 | 25 | 660 | Ar |
| 370 | 1020 | 1320 | Ar |
| 440 | 1100 | 1652 | Ar |
| 560 | 1100 | 1652 | Ar |
| 620 | 1200 | 1982 | Ar |
| 660 | 1200 | 1982 | Ar |
| 720 | 1300 | 1982 | Ar |
| 780 | 1300 | 2312 | Ar |
| 840 | 1300 | 2646 | Ar |
| 920 | 1400 | 2646 | Ar |
| 980 | 1400 | 2646 | Ar |
| 1050 | 1500 | 2646 | Ar |
| 1330 | 1500 | 2646 | Ar |
| 1370 | 1450 | 0 | Ar |

After hot pressing, the disk was ground and polished on the yttria side prior to color measurements in various locations on the component, also referred to as disk or window. Color measurements were obtained using a Hunterlab Miniscan XE instrument using the CieLab L*,a*,b* scale. Measurement locations were selected visually by the operator to represent variations in uniformity. For Sample A, large fragments of the window were selected for measurement in one area where the color was judged by eye to be the darkest and two areas where the color was judged by eye to be the lightest. Sample A showed unacceptable color uniformity. Results are included in Table 15.

### Example 12 (not forming part of the invention)

For Sample B, a 580 mm disk was prepared in the same manner as for Sample A, except that the temperature and pressure cycles for hot pressing are shown in Table 14. Processing of Sample B also included a separate heat treating step as described below.

**Table 14. Temperature & Pressure Cycle during Example 12 Hot Pressing.**

| Time (min) | Setpoint, °C | Pressure (psi) | Atmos. |
|---|---|---|---|
| 0.0 | 25 | 660 | Ar |
| 370 | 1005 | 1320 | Ar |
| 440 | 1100 | 1652 | Ar |
| 560 | 1100 | 1652 | Ar |
| 630 | 1200 | 1982 | Ar |
| 760 | 1200 | 1982 | Ar |
| 900 | 1300 | 1982 | Ar |
| 960 | 1300 | 2312 | Ar |
| 1020 | 1300 | 2646 | Ar |
| 1160 | 1400 | 2646 | Ar |
| 1280 | 1400 | 2646 | Ar |
| 1420 | 1500 | 2646 | Ar |
| 1780 | 1500 | 2646 | Ar |
| 1830 | 1470 | 0 | Ar |

After hot pressing, the Sample B disk was additionally heat treated in air at 1200 °C for 4 hours, then ground and polished on the yttria side. By visual observation, the whiteness of Sample B was observed to be enhanced over Sample A. Color was measured using a Hunterlab Miniscan XE instrument as with Sample A. For Sample B, large fragments of the window were selected for measurement in two areas where the color was judged by eye to be the darkest and two areas where the color was judged by eye to be the lightest. Measurement results, included in Table 15, show Sample B to be fairly white with an L* consistently greater than 88. Shading and hue variations are evidenced by the difference in L* between locations of more than 5 and the difference of a* or b* of more than 3, respectively.

### Example 13

For Sample C, a 580 mm disk was prepared in the same manner as for Sample B except that the yttria layer and the interposing ytterbia layer of Sample C both further include zirconia as sintering aid. Before the yttria powder was added to the mold, 1 mole per cent of TZ3Y powder (5.2 wt% Y₂O₃ in ZrO₂, supplied by Tosoh Corp.) was mixed into the Y₂O₃ powder using a Resodyn mixer. For the ytterbia powder, 1 mole per cent of TZ3Y powder was attrition milled together with the ytterbia, followed by spray drying of the resulting slurry. The resulting powder was then used. After hot pressing, the disk was then heat treated in air at 1200 °C for 4 hours. Sample C was then ground and polished on the yttria side. Color was measured using a Hunterlab Miniscan XE instrument as with Samples A and B. For Sample C, large fragments of the window were selected for measurement in one area where the color was judged by eye to be the darkest and two areas where the color was judged by eye to be the lightest. Measurement results, included in Table 15, show Sample C to be white with an L* consistently greater than 92. Shading and hue variations are less than for Samples A and B as evidenced by the difference in L* between locations of less than 5 and the difference of a* or b* of less than 3, respectively. Average grain size of the yttria layer for Sample C was measured to be 5.4 µm as determined by ASTM E112-96. Average grain size of the ytterbia layer for Sample C was measured to be 0.5 µm as determined by ASTM E112-96. The porosity was measured to be less than 1% for the ytterbia layer of Sample C. Carbon content for Sample C was measured by combustion to be less than 30 parts per million by weight.

**Table 15. L*a*b* Results for Examples 11-13.**

| Sample | Location | L* | a* | b* |
|---|---|---|---|---|
| A | 1 | 82.04 | -0.03 | 1.29 |
| A | 2 | 77.57 | -0.03 | 1.28 |
| A | 3 | 67.72 | -0.01 | 1.29 |
| B | 1 | 96.44 | 0.01 | 1.46 |
| B | 2 | 92.49 | 0.15 | 4.20 |
| B | 3 | 90.57 | 0.17 | 3.05 |
| B | 4 | 93.85 | -0.63 | -0.27 |
| C | 1 | 92.04 | -0.61 | 0.44 |
| C | 2 | 94.62 | 0.50 | 1.21 |
| C | 3 | 96.53 | 0.54 | 2.40 |

### Listing of Elements

- 100: corrosion-resistant component
- 110: ceramic insulating substrate
- 120: corrosion-resistant non-porous layer
- 130: interposing layer
- 150: corrosion-resistant non-porous layer
- t1: thickness of layer 120
- t2: thickness of layer 130
- 200: plasma etch reactor assembly
- 210: ceramic insulating substrate
- 220: corrosion-resistant non-porous layer
- 225: lid
- 240: induction coil
- 250: reactor
- 300: heater apparatus
- 320: corrosion-resistant non-porous layer
- 330: interposing layer
- 330: insulating ceramic
- 340: heating element(s)
- 360: radio-frequency (RF) shield
- 380: supporting disk
- 400: CVD reactor assembly
- 410: showerhead
- 420: corrosion-resistant non-porous layer
- 440: heater
- 450: wafer being processed
- 600: plasma etch reactor assembly
- 605: center or axial void
- 610: ceramic insulating substrate
- 620: corrosion-resistant non-porous layer
- 625: lid
- 640: induction coil
- 650: wafer
- 670: central region of the inner planar surface of 620
- 680: outer region
- 700: reactor

**Table 12. Summary of Properties.**

| Sample ID | Y₂O₃ Thickness (µm) | Yb₂O₃ Thickness (µm) | Porosity (%) | Loss Tangent ( × 10⁻⁵) | L* | Adhesion (MPa) | Grain Size Alumina (µm) | Grain Size Yttria (µm) | Carbon (ppm) |
|---|---|---|---|---|---|---|---|---|---|
| 1 | 908 | - | 0.24 | 9.1 | 53.9 | 30 | 1.7 | - | 640 |
| 4 | 799 | - | 0.5 | 11 | 49.7 | 20 | 0.76 | 0.4 | - |
| 5 | 626 | - | 0.69 | 15.7 | 66.1 | 26 | 0.92 | - | - |
| 6 | - | - | - | 4 | 75.4 | 24 | - | - | - |
| 7 | - | - | - | 53.2 | 75.9 | 35 | - | - | - |
| 8 | - | - | - | 2.3 | 76.0 | <5 | - | - | - |
| 9 | - | - | - | 4.6 | 48.6 | 38 | - | - | - |
| 10 | 920 | 530 | 1 | 15 | 49.7 | 28 | - | - | - |
| 11 | 704 | 447 | 0.66 | - | - | - | - | - | - |
| 12 | 935 | 524 | 0.72 | - | - | - | - | - | - |
| 43 | 2950 | 525 | - | - | - | - | - | - | - |
| 49 | 1215 (top layer) | - | <1 | 13.3 | - | 32 | - | 2 | - |
| 50 | 720 | 350 | - | 2.4 | - | - | - | 2 | - |
| 54 | 985 | 40 | - | 3.9 | - | - | - | 5 - 20 | - |
| 55 | 1000 | 315 | - | 2.1 | - | - | - | 5 - 20 | - |
| 57 | 1085 | 380 | - | 4.5 | - | - | - | 50 | - |
| 58 | 980 | 425 | - | 7.7 | - | - | - | 5-10 | - |

### OTHER EMBODIMENTS

A number of variations and modifications of the disclosure can be used. It would be possible to provide for some features of the disclosure without providing others.

The present disclosure, in various aspects, embodiments, and configurations, includes components, methods, processes, systems and/or apparatus substantially as depicted and described herein, including various aspects, embodiments, configurations, subcombinations, and subsets thereof. Those of skill in the art will understand how to make and use the various aspects, aspects, embodiments, and configurations, after understanding the present disclosure. The present disclosure, in various aspects, embodiments, and configurations, includes providing devices and processes in the absence of items not depicted and/or described herein or in various aspects, embodiments, and configurations hereof, including in the absence of such items as may have been used in previous devices or processes, for example, for improving performance, achieving ease and/or reducing cost of implementation.

The foregoing discussion of the disclosure has been presented for purposes of illustration and description. The foregoing is not intended to limit the disclosure to the form or forms disclosed herein. In the foregoing Detailed Description for example, various features of the disclosure are grouped together in one or more, aspects, embodiments, and configurations for the purpose of streamlining the disclosure. The features of the aspects, embodiments, and configurations of the disclosure may be combined in alternate aspects, embodiments, and configurations other than those discussed above. This method of disclosure is not to be interpreted as reflecting an intention that the claimed disclosure requires more features than are expressly recited in each claim.

## Claims

1. A corrosion-resistant component configured for use with a semiconductor processing reactor, the corrosion-resistant component comprising:
a) a ceramic insulating substrate;
b) a corrosion-resistant non-porous outer layer adhered to the ceramic insulating substrate, the corrosion-resistant non-porous outer layer having a thickness of at least 50 µm, a porosity of at most 1%, and a composition comprising at least 15% by weight of a rare earth compound based on total weight of the corrosion-resistant non-porous outer layer and a first sintering aid added to the rare-earth compound in the range from 300 ppm to 20% by weight based upon total weight of the rare-earth compound;
c) at least one interposing layer embedded in the ceramic insulating substrate or layered between the ceramic insulating substrate and the corrosion-resistant non-porous outer layer, wherein the at least one interposing layer is ytterbium oxide, wherein the at least one interposing layer further comprises a second sintering aid added to the ytterbium oxide in the range from 300 ppm to 20% by weight based upon total weight of the ytterbium oxide; and
d) a carbon content of at most 1000 ppm.

2. The corrosion-resistant component of claim 1, wherein the ceramic insulating substrate is selected from the group consisting of aluminum oxide, aluminum nitride, silicon nitride, silicate-based materials, and mixtures of two or more thereof.

3. The corrosion-resistant component of claim 1 or claim 2, wherein the first sintering aid is at least one material chosen from ZrO₂, HfO₂, and CeO₂ and the second sintering aid is at least one material chosen from ZrO₂, HfO₂, and CeO₂.

4. The corrosion-resistant component of any preceding claim, wherein the first sintering aid added to the rare-earth compound is in the range from 0.5% by weight to 15% by weight based upon total weight of the rare-earth compound.

5. The corrosion-resistant component of any of the preceding claims, wherein the first sintering aid added to the rare-earth compound is ZrO₂ in the amount of 1% by weight based upon total weight of the rare-earth compound.

6. A method for preparing the corrosion-resistant component of claim 1, the method comprising:
laying up a first layer of a sinterable powder composition comprising at least 15% by weight of a rare earth compound based on total weight of the first layer, wherein a first sintering aid is added to the rare earth compound, and a second layer of sinterable substrate material to form a pre-laminate, wherein the sinterable substrate material is selected from the group consisting of aluminum oxide, aluminum nitride, silicon nitride, silicate-based materials and mixtures of two or more thereof; and wherein the first layer is less than 50% as thick as the second layer;
laying up at least one interposing layer of sinterable powder layered between the first layer and the second layer, wherein the sinterable powder is ytterbium oxide; and wherein a second sintering aid is added to the interposing layer in the range from 300 ppm to 20% by weight based upon total weight of the ytterbium oxide;
heat treating by either hot pressing or hot isostatic pressing the pre-laminate to form a corrosion-resistant component, including a corrosion-resistant non-porous outer layer, having a thickness of at least 50 µm and a porosity of at most 1%, to form a corrosion-resistant laminate having a carbon content of at most 1000 ppm.

7. The method of claim 6, wherein the first sintering aid is at least one material chosen from ZrO₂, HfO₂, and CeO₂ and the second sintering aid is at least one material chosen from ZrO₂, HfO₂, and CeO₂.

8. The method of any of claims 6 or 7, wherein the first sintering aid added to the rare-earth compound is in the range from 0.5% by weight to 15% by weight based upon total weight of the rare-earth compound

9. The method of any of claims 6-8, wherein the first sintering aid added to the rare-earth compound is ZrO₂ in the amount of 1% by weight based upon total weight of the rare earth compound.

10. The corrosion-resistant component or method of any of the preceding claims, wherein the rare earth compound is selected from the group consisting of yttrium oxide (Y₂O₃), yttrium silicates, yttrium fluorides, yttrium oxyfluorides, yttrium aluminates, nitrides, and combinations of two or more thereof.

11. The corrosion-resistant component or method of any of the preceding claims, wherein the rare earth compound is yttrium oxide (Y₂O₃).

## Patentansprüche

1. Korrosionsbeständige Komponente, die zur Verwendung mit einem Halbleiterverarbeitungsreaktor konfiguriert ist, wobei die korrosionsbeständige Komponente Folgendes umfasst:
a) ein keramisches Isoliersubstrat;
b) eine korrosionsbeständige nichtporöse Außenschicht, die an dem keramischen Isoliersubstrat haftet, wobei die korrosionsbeständige nichtporöse Außenschicht eine Dicke von zumindest 50 µm, eine Porosität von höchstens 1 % und eine Zusammensetzung aufweist, die zumindest 15 Gew.-% einer Seltenerdverbindung basierend auf Gesamtgewicht der korrosionsbeständigen nichtporösen Außenschicht und eine erste Sinterhilfe, die der Seltenerdverbindung in dem Bereich von 300 ppm bis 20 Gew.-% basierend auf Gesamtgewicht der Seltenerdverbindung hinzugefügt ist, umfasst;
c) zumindest eine Zwischenschicht, die in das keramische Isoliersubstrat eingebettet oder zwischen dem keramischen Isoliersubstrat und der korrosionsbeständigen nichtporösen Außenschicht geschichtet ist, wobei die zumindest eine Zwischenschicht Ytterbiumoxid ist, wobei die zumindest eine Zwischenschicht ferner eine zweite Sinterhilfe umfasst, die dem Ytterbiumoxid in dem Bereich von 300 ppm bis 20 Gew.-% basierend auf Gesamtgewicht des Ytterbiumoxids hinzugefügt ist; und
d) einen Kohlenstoffgehalt von höchstens 1000 ppm.

2. Korrosionsbeständige Komponente nach Anspruch 1, wobei das keramische Isoliersubstrat ausgewählt ist aus der Gruppe bestehend aus Aluminiumoxid, Aluminiumnitrid, Siliziumnitrid, Materialien auf Silikatbasis und Mischungen aus zwei oder mehr davon.

3. Korrosionsbeständige Komponente nach Anspruch 1 oder Anspruch 2, wobei die erste Sinterhilfe zumindest ein Material ist, das gewählt ist aus ZrO₂, HfO₂ und CeO₂ und die zweite Sinterhilfe zumindest ein Material ist, das gewählt ist aus ZrO₂, HfO₂ und CeO₂.

4. Korrosionsbeständige Komponente nach einem vorhergehenden Anspruch, wobei die erste Sinterhilfe, die der Seltenerdverbindung hinzugefügt ist, in dem Bereich von 0,5 Gew.-% bis 15 Gew.-% basierend auf Gesamtgewicht der Seltenerdverbindung ist.

5. Korrosionsbeständige Komponente nach einem der vorhergehenden Ansprüche, wobei die erste Sinterhilfe, die der Seltenerdverbindung hinzugefügt ist, ZrO₂ in der Menge von 1 Gew.-% basierend auf Gesamtgewicht der Seltenerdverbindung ist.

6. Verfahren zur Herstellung der korrosionsbeständigen Komponente nach Anspruch 1, wobei das Verfahren Folgendes umfasst:
Aufbringen einer ersten Schicht aus einer sinterbaren Pulverzusammensetzung, die zumindest 15 Gew.-% einer Seltenerdverbindung basierend auf Gesamtgewicht der ersten Schicht umfasst, wobei eine erste Sinterhilfe der Seltenerdverbindung hinzugefügt ist, und einer zweiten Schicht aus sinterbarem Substratmaterial, um ein Vorlaminat zu bilden, wobei das sinterbare Substratmaterial ausgewählt ist aus der Gruppe bestehend aus Aluminiumoxid, Aluminiumnitrid, Siliziumnitrid, Materialien auf Silikatbasis und Mischungen aus zwei oder mehr davon; und wobei die erste Schicht weniger als 50 % so dick wie die zweite Schicht ist;
Aufbringen von zumindest einer Zwischenschicht aus sinterbarem Pulver geschichtet zwischen der ersten Schicht und der zweiten Schicht, wobei das sinterbare Pulver Ytterbiumoxid ist; und wobei eine zweite Sinterhilfe der Zwischenschicht in dem Bereich von 300 ppm bis 20 Gew.-% basierend auf Gesamtgewicht des Ytterbiumoxids hinzugefügt ist;
Wärmebehandeln durch entweder Heißpressen oder heißisostatisches Pressen des Vorlaminats, um eine korrosionsbeständige Komponente zu bilden, beinhaltend eine korrosionsbeständige nichtporöse Außenschicht mit einer Dicke von zumindest 50 µm und einer Porosität von höchstens 1 %, um ein korrosionsbeständiges Laminat mit einem Kohlenstoffgehalt von höchstens 1000 ppm zu bilden.

7. Verfahren nach Anspruch 6, wobei die erste Sinterhilfe zumindest ein Material gewählt aus ZrO₂, HfO₂ und CeO₂ ist und die zweite Sinterhilfe zumindest ein Material gewählt aus ZrO₂, HfO₂ und CeO₂ ist.

8. Verfahren nach einem der Ansprüche 6 oder 7, wobei die Sinterhilfe, die der Seltenerdverbindung hinzugefügt ist, in dem Bereich von 0,5 Gew.-% bis 15 Gew.-% basierend auf Gesamtgewicht der Seltenerdverbindung ist.

9. Verfahren nach einem der Ansprüche 6-8, wobei die erste Sinterhilfe, die der Seltenerdverbindung hinzugefügt ist, ZrO₂ in der Menge von 1 Gew.-% basierend auf Gesamtgewicht der Seltenerdverbindung ist.

10. Korrosionsbeständige Komponente oder Verfahren nach einem der vorhergehenden Ansprüche, wobei die Seltenerdverbindung ausgewählt ist aus der Gruppe bestehend aus Yttriumoxid (Y₂O₃), Yttriumsilikaten, Yttriumfluoriden, Yttriumoxyfluoriden, Yttriumaluminaten, Nitriden und Kombinationen aus zwei oder mehr davon.

11. Korrosionsbeständige Komponente oder Verfahren nach einem der vorhergehenden Ansprüche, wobei die Seltenerdverbindung Yttriumoxid (Y₂O₃) ist.

## Revendications

1. Composant résistant à la corrosion configuré pour être utilisé avec un réacteur de traitement de semi-conducteur, le composant résistant à la corrosion comprenant :
a) un substrat isolant en céramique ;
b) une couche externe non poreuse résistante à la corrosion adhérant au substrat isolant en céramique, la couche externe non poreuse résistante à la corrosion comportant une épaisseur d'au moins 50 µm, une porosité d'au plus 1 %, et une composition comprenant au moins 15 % en poids d'un composé de terres rares sur la base du poids total de la couche externe non poreuse résistante à la corrosion et un premier adjuvant de frittage ajouté au composé de terres rares dans la plage de 300 ppm à 20 % en poids sur la base du poids total du composé de terres rares ;
c) au moins une couche intercalaire intégrée dans le substrat isolant en céramique ou superposée entre le substrat isolant en céramique et la couche externe non poreuse résistante à la corrosion, dans lequel l'au moins une couche intercalaire est l'oxyde d'ytterbium, dans lequel l'au moins une couche intercalaire comprend en outre un deuxième adjuvant de frittage ajouté à l'oxyde d'ytterbium dans la plage de 300 ppm à 20 % en poids sur la base du poids total de l'oxyde d'ytterbium ; et
d) une teneur en carbone d'au plus 1000 ppm.

2. Composant résistant à la corrosion selon la revendication 1, dans lequel le substrat isolant en céramique est choisi dans le groupe constitué de l'oxyde d'aluminium, du nitrure d'aluminium, du nitrure de silicium, des matériaux à base de silicate et des mélanges de deux ou plus de ceux-ci.

3. Composant résistant à la corrosion selon la revendication 1 ou la revendication 2, dans lequel le premier adjuvant de frittage est au moins un matériau choisi parmi ZrO₂, HfO₂, et CeO₂ et le second adjuvant de frittage est au moins un matériau choisi parmi ZrO₂, HfO₂, et CeO₂.

4. Composant résistant à la corrosion selon l'une quelconque des revendications précédentes, dans lequel le premier adjuvant de frittage ajouté au composé de terres rares est compris dans la plage de 0,5 % en poids à 15 % en poids sur la base du poids total du composé de terres rares.

5. Composant résistant à la corrosion selon l'une quelconque des revendications précédentes, dans lequel le premier adjuvant de frittage ajouté au composé de terres rares est du ZrO₂ à raison de 1 % en poids sur la base du poids total du composé de terres rares.

6. Procédé de préparation du composant résistant à la corrosion selon la revendication 1, le procédé comprenant :
le dépôt d'une première couche d'une composition de poudre frittable comprenant au moins 15 % en poids d'un composé de terres rares sur la base du poids total de la première couche, dans lequel un premier adjuvant de frittage est ajouté au composé de terres rares, et une seconde couche de matériau de substrat frittable pour former un préstratifié, dans lequel le matériau de substrat frittable est choisi dans le groupe constitué d'oxyde d'aluminium, nitrure d'aluminium, nitrure de silicium, matériaux à base de silicate et des mélanges de deux ou plus de ceux-ci ; et dans lequel la première couche est inférieure à 50 % de l'épaisseur de la deuxième couche ;
le dépôt d'au moins une couche intercalaire de poudre frittable disposée entre la première couche et la deuxième couche, dans lequel la poudre frittable est de l'oxyde d'ytterbium ; et dans lequel un second adjuvant de frittage est ajouté à la couche intercalaire dans une plage allant de 300 ppm à 20 % en poids sur la base du poids total de l'oxyde d'ytterbium ;
le traitement thermiquement par pressage à chaud ou pressage isostatique à chaud du préstratifié pour former un composant résistant à la corrosion, comprenant une couche externe non poreuse résistante à la corrosion, comportant une épaisseur d'au moins 50 µm et une porosité d'au plus 1 %, pour former un stratifié résistant à la corrosion comportant une teneur en carbone d'au plus 1 000 ppm.

7. Procédé selon la revendication 6, dans lequel le premier adjuvant de frittage est au moins un matériau choisi parmi ZrO₂, HfO₂, et CeO₂ et le second adjuvant de frittage est au moins un matériau choisi parmi ZrO₂, HfO₂, et CeO₂.

8. Procédé selon l'une quelconque des revendications 6 ou 7, dans lequel le premier adjuvant de frittage ajouté au composé de terres rares est compris dans la plage de 0,5 % en poids à 15 % en poids sur la base du poids total du composé de terres rares.

9. Procédé selon l'une quelconque des revendications 6 à 8, dans lequel le premier adjuvant de frittage ajouté au composé de terres rares est le ZrO₂ à raison de 1 % en poids sur la base du poids total du composé de terres rares.

10. Composant ou procédé résistant à la corrosion selon l'une quelconque des revendications précédentes, dans lequel le composé de terres rares est choisi dans le groupe constitué de l'oxyde d'yttrium (Y₂O₃), des silicates d'yttrium, des fluorures d'yttrium, des oxyfluorures d'yttrium, des aluminates d'yttrium, des nitrures et des combinaisons de deux ou plus d'entre eux.

11. Composant résistant à la corrosion ou procédé selon l'une quelconque des revendications précédentes, dans lequel le composé de terres rares est l'oxyde d'yttrium (Y₂O₃).
